(19)

Europäisches
Patentamt
European
Patent Office
Office européen
des brevets

(11) **EP 3 899 801 B1**

(12) **EUROPEAN PATENT SPECIFICATION**

(45) Date of publication and mention
of the grant of the patent:
**09.07.2025 Bulletin 2025/28**

(21) Application number: **19828507.4**

(22) Date of filing: **10.12.2019**

(51) International Patent Classification (IPC):
**G06N 3/084** (2023.01)    **G06N 3/044** (2023.01)
**G06N 3/045** (2023.01)    **G06N 3/048** (2023.01)
**G06N 3/063** (2023.01)

(52) Cooperative Patent Classification (CPC):
**G06N 3/084; G06N 3/044; G06N 3/045;**
**G06N 3/048;** G06N 3/063

(86) International application number:
**PCT/US2019/065306**

(87) International publication number:
**WO 2020/131464 (25.06.2020 Gazette 2020/26)**

(54) **SCALED LEARNING FOR TRAINING DEEP NEURAL NETWORKS**

SKALIERTES LERNEN ZUM TRAINIEREN VON DNN

APPRENTISSAGE MIS À L'ÉCHELLE POUR APPRENTISSAGE DE DNN

(84) Designated Contracting States:
**AL AT BE BG CH CY CZ DE DK EE ES FI FR GB**
**GR HR HU IE IS IT LI LT LU LV MC MK MT NL NO**
**PL PT RO RS SE SI SK SM TR**

(30) Priority: **19.12.2018 US 201816226475**

(43) Date of publication of application:
**27.10.2021 Bulletin 2021/43**

(73) Proprietor: **Microsoft Technology Licensing, LLC**
**Redmond, WA 98052-6399 (US)**

(72) Inventors:
• **ROUHANI DARVISH, Bita**
**Redmond, Washington 98052-6399 (US)**
• **CHUNG, Eric S.**
**Redmond, Washington 98052-6399 (US)**
• **LO, Daniel**
**Redmond, Washington 98052-6399 (US)**
• **BURGER, Douglas C.**
**Redmond, Washington 98052-6399 (US)**

(74) Representative: **Grünecker Patent- und**
**Rechtsanwälte**
**PartG mbB**
**Leopoldstraße 4**
**80802 München (DE)**

(56) References cited:
**US-A1- 2016 328 647**

• **LU HOU ET AL: "Loss-aware Weight**
**Quantization of Deep Networks", ARXIV.ORG,**
**CORNELL UNIVERSITY LIBRARY, 201 OLIN**
**LIBRARY CORNELL UNIVERSITY ITHACA, NY**
**14853, 23 February 2018 (2018-02-23),**
**XP081232130**
• **YINPENG DONG ET AL: "Learning Accurate Low-**
**Bit Deep Neural Networks with Stochastic**
**Quantization", 3 August 2017 (2017-08-03),**
**XP055454962, Retrieved from the Internet**
**<URL:https://arxiv.org/pdf/1708.01001.pdf>**
• **DYLAN MALONE STUART ET AL: "Investigating**
**the Effects of Dynamic Precision Scaling on**
**Neural Network Training", ARXIV.ORG,**
**CORNELL UNIVERSITY LIBRARY, 201 OLIN**
**LIBRARY CORNELL UNIVERSITY ITHACA, NY**
**14853, 25 January 2018 (2018-01-25),**
**XP080854809**

EP 3 899 801 B1

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

## Description

## BACKGROUND

Machine learning (ML) and artificial intelligence (AI) techniques can be useful for solving a number of complex computational problems such as recognizing images and speech, analyzing and classifying information, and performing various classification tasks. Machine learning is a field of computer science that uses statistical techniques to give computer systems the ability to extract higher-level features from a set of training data. Specifically, the features can be extracted by training a model such as an artificial neural network or a deep neural network. Traditionally, deep neural networks have been trained and deployed using values in single-precision floating-point format (e.g., float32). Recent research has shown that lower-precision quantized formats, such as float16 or fixed-point, can be used for inference with an acceptable loss in accuracy. However, as the precision is lowered errors (also referred to as "noise") can increase.

Lu Hou et al: "Loss-aware Weight Quantization of Deep Networks", Arxiv.Org, Cornell University Library, 201 Olin Library Cornell University ITHACA, NY 14853, 23 February 2018, discloses compressing the network by weight quantization. The authors propose a loss-aware weight binarization scheme to ternarization, with possibly different scaling parameters for the positive and negative weights, and m-bit (where m > 2) quantization.

Yinpeng Dong et al: "Learning Accurate Low-Bit Deep Neural Networks with Stochastic Quantization", 3 August 2017, discloses the stochastic quantization (SQ) algorithm for learning accurate low-bit DNNs. Existing training algorithms approximate the real-valued elements/filters with low-bit representation all together in each iteration. The quantization errors may be small for some elements/filters, while are remarkable for others, which lead to inappropriate gradient direction during training, and thus bring notable accuracy drop. Instead, SQ quantizes a portion of elements/filters to low-bit with a stochastic probability inversely proportional to the quantization error, while keeping the other portion unchanged with full-precision. The quantized and full-precision portions are updated with corresponding gradients separately in each iteration. The SQ ratio is gradually increased until the whole network is quantized. This procedure can greatly compensate the quantization error and thus yield better accuracy for low-bit DNNs.

Dylan Malone Stuart et al: "Investigating the Effects of Dynamic Precision Scaling on Neural Network Training", Arxiv.Org, Cornell University Library, 201 Olin Library Cornell University ITHACA, NY 14853, 25 January 2018, discloses a novel dynamic precision scaling scheme using stochastic fixed-point rounding, a quantization-error based scaling scheme, and dynamic bit-widths during training.

US 2016/0328647 A1 discloses a method for selecting bit widths for a fixed point machine learning model that includes evaluating a sensitivity of model accuracy to bit widths at each computational stage of the model. The method also includes selecting a bit width for parameters, and/or intermediate calculations in the computational stages of the mode. The bit width for the parameters and the bit width for the intermediate calculations may be different. The selected bit width may be determined based on the sensitivity evaluation.

## SUMMARY

It is the object of the present invention to provide an improved method and system for adjusting hyper-parameters to compensate for noise when training a neural network.

This object is solved by the subject matter of the independent claims.

Preferred embodiments are defined by the dependent claims.

Methods and apparatus are disclosed for compensating for quantization noise during training of a neural network implemented with a quantization-enabled system. In some examples, a method for training a neural network includes obtaining a tensor including values of one or more parameters of the neural network represented in a quantized-precision format and generating at least one metric (e.g., at least one noise-to-signal metric) representing quantization noise present in the tensor. The parameters can include edge weights and activation weights of the neural network, for example. The at least one metric can then be used to scale a learning rate, for use in a back-propagation phase of one or more subsequent training epochs of the neural network.

As used herein, the "noise-to-signal" metric refers to the quantitative relationship between the portion of a signal (e.g., a signal representing a parameter value) that is considered "noise," and the signal itself. For example, quantization of a value of a parameter (e.g., an activation weight or edge weight of a neural network) can introduce noise, as the value is represented with lower precision in the quantized format. In such an example, the noise-to-signal metric can include a ratio of the portion of the quantized value that constitutes noise to the value of the parameter prior to quantization.

As will be readily understood by one of ordinary skill in the relevant art having the benefit of the present disclosure, in examples where the noise-to-signal metric is a ratio, it is not limited to ratios of scalar noise and signal values. Rather, it can also include ratios in which the numerator and denominator are not scalar values. For example, the noise-to-signal ratio metric can represent a ratio of a noise vector containing a plurality of noise values to a signal vector containing a plurality of signal values (e.g., values of a parameters of a single layer of a neural network), where each noise value in the noise vector represents the portion of a corresponding signal of the signal vector that is considered "noise," and each corresponding signal value in the signal vector represents the signal itself. As another example, the noise-to-signal ratio metric can represent a ratio of a noise matrix containing a plurality of noise values to a signal matrix containing a plurality of signal values (e.g., values of a parameters of multiple layers of the neural network), where each noise value in the noise matrix represents the portion of a corresponding signal of the signal matrix that is considered "noise," and each corresponding signal value in the signal matrix represents the signal itself. Thus, if the noise-to-signal ratio is envisioned as a fraction, the numerator and denominator can be scalar values, vectors, or matrices. Alternatively, the numerator and denominator of the noise-to-signal ratio can take another form without departing from the scope of the appended claims.

In another implementation, the noise-to-signal metric has a form other than a ratio.

During the subsequent training epochs of the quantized neural network, a scaling factor computed based on the at least one noise-to-signal metric can be used to scale the learning rate used to compute a gradient update for parameters of the neural network. As will be readily apparent to one of ordinary skill in the art having the benefit of the present disclosure, by adjusting hyper-parameters of the neural network, such as learning rate, based on the quantization noise-to-signal ratio, errors arising during computation of gradient updates due to aggregated quantization noise can be mitigated. Such noise compensation advantageously allows lower-precision calculations to be used in training a neural network while still achieving similar accuracy to higher-precision calculations. Some amount of noise can be beneficial for training a neural network, as it can reduce the risk of the neural network over-fitting to the data. Indeed, for each neural network, there can be an optimal amount of random fluctuation in the dynamics. However, when performing back propagation in a neural network having values in lower-precision quantized formats, quantization noise from the different layers aggregates. Due to this aggregation of noise, errors in the computation of gradient updates during back propagation can reach unacceptable levels.

In some examples of the disclosed technology, hyper-parameters of the neural network can be adjusted to compensate for noise originating from sources other than quantization. For example, a method for compensating for noise during training of a neural network can include computing at least one noise-to-signal ratio representing noise present in the neural network. The computed noise-to-signal ratio(s) can then be used in adjusting a hyper-parameter of the neural network, such as a learning rate, learning rate schedule, bias, stochastic gradient descent batch size, number of neurons in the neural network, number of layers in the neural network, etc. The neural network can then be trained using the adjusted hyper-parameter. For example, the adjusted hyper-parameter can factor into the computation of gradient updates during a back-propagation phase of a subsequent training epoch of the neural network. Accordingly, techniques which introduce noise but improve the efficiency of neural network training can be utilized, without compromising the accuracy of the training results.

This Summary is provided to introduce a selection of concepts in a simplified form that are further described below in the Detailed Description. This Summary is not intended to identify key features or essential features of the claimed subject matter, nor is it intended to be used to limit the scope of the claimed subject matter.

The foregoing and other objects, features, and advantages of the disclosed subject matter will become more apparent from the following detailed description, which proceeds with reference to the accompanying figures.

## BRIEF DESCRIPTION OF THE DRAWINGS

FIG. 1 is a block diagram of a quantization-enabled system, as can be implemented in certain examples of the disclosed technology.

FIG. 2 is a diagram depicting a deep neural network, as can be modeled using certain example methods and apparatus disclosed herein.

FIG. 3 is a flow chart outlining an example method of scaling a learning rate used for training a quantized neural network, as can be performed in certain examples of the disclosed technology.

FIG. 4 is a flow chart outlining an example method of adjusting a hyper-parameter to compensate for noise when training a neural network, as can be implemented in certain examples of the disclosed technology.

FIG. 5 is a diagram illustrating an example computing environment in which certain examples of the disclosed technology can be implemented.

FIGS. 6-9 are charts illustrating experimental results that can be observed when performing certain examples of the disclosed technology.

## DETAILED DESCRIPTION

## I. General Considerations

This disclosure is set forth in the context of representative embodiments that are not intended to be limiting in any way.

As used in this application the singular forms "a," "an," and "the" include the plural forms unless the context clearly dictates otherwise. Additionally, the term "includes" means "comprises." Further, the term "coupled" encompasses mechanical, electrical, magnetic, optical, as well as other practical ways of coupling or linking items together, and does not exclude the presence of intermediate elements between the coupled items. Furthermore, as used herein, the term "and/or" means any one item or combination of items in the phrase.

The systems, methods, and apparatus described herein should not be construed as being limiting in any way. Instead, this disclosure is directed toward all novel and non-obvious features and aspects of the various disclosed embodiments, alone and in various combinations and subcombinations with one another. The disclosed systems, methods, and apparatus are not limited to any specific aspect or feature or combinations thereof, nor do the disclosed things and methods require that any one or more specific advantages be present or problems be solved. Furthermore, any features or aspects of the disclosed embodiments can be used in various combinations and subcombinations with one another.

Although the operations of some of the disclosed methods are described in a particular, sequential order for convenient presentation, it should be understood that this manner of description encompasses rearrangement, unless a particular ordering is required by specific language set forth below. For example, operations described sequentially may in some cases be rearranged or performed concurrently. Moreover, for the sake of simplicity, the attached figures may not show the various ways in which the disclosed things and methods can be used in conjunction with other things and methods. Additionally, the description sometimes uses terms like "produce," "generate," "perform," "select," "receive," "emit," "verify," and "convert" to describe the disclosed methods. These terms are high-level descriptions of the actual operations that are performed. The actual operations that correspond to these terms will vary depending on the particular implementation and are readily discernible by one of ordinary skill in the art having the benefit of the present disclosure.

Theories of operation, scientific principles, or other theoretical descriptions presented herein in reference to the apparatus or methods of this disclosure have been provided for the purposes of better understanding and are not intended to be limiting the scope of the appended claims.

Any of the disclosed methods can be implemented as computer-executable instructions stored on one or more computer-readable media (e.g., computer-readable media, such as one or more optical media discs, volatile memory components (such as DRAM or SRAM), or nonvolatile memory components (such as hard drives)) and executed on a computer (e.g., any commercially available computer, including smart phones or other mobile devices that include computing hardware). Any of the computer-executable instructions for implementing the disclosed techniques, as well as any data created and used during implementation of the disclosed embodiments, can be stored on one or more computer-readable media (e.g., computer-readable storage media). The computer-executable instructions can be part of, for example, a dedicated software application, or a software application that is accessed or downloaded via a web browser or other software application (such as a remote computing application). Such software can be executed, for example, on a single local computer (e.g., with general-purpose and/or specialized processors executing on any suitable commercially available computer) or in a network environment (e.g., via the Internet, a wide-area network, a local-area network, a client-server network (such as a cloud computing network), or other such network) using one or more network computers.

For clarity, only certain selected aspects of the software-based implementations are described. Other details that are well known in the art are omitted. For example, it should be understood that the disclosed technology is not limited to any specific computer language or program. For instance, the disclosed technology can be implemented by software written in C, C++, Java, or any other suitable programming language. Likewise, the disclosed technology is not limited to any particular computer or type of hardware. Certain details of suitable computers and hardware are well-known and need not be set forth in detail in this disclosure.

Furthermore, any of the software-based embodiments (comprising, for example, computer-executable instructions for causing a computer to perform any of the disclosed methods) can be uploaded, downloaded, or remotely accessed through a suitable communication means. Such suitable communication means include, for example, the Internet, the World Wide Web, an intranet, software applications, cable (including fiber optic cable), magnetic communications, electromagnetic communications (including RF, microwave, and infrared communications), electronic communications, or other such communication means.

## II. Introduction to Neural Networks and Quantized Formats

Artificial Neural Networks (ANNs or as used throughout herein, "NNs") are applied to a number of applications in Artificial Intelligence and Machine Learning including image recognition, speech recognition, search engines, and other suitable applications. The processing for these applications may take place on individual devices such as personal computers or cell phones, but it may also be performed in large datacenters. At the same time, hardware accelerators that can be used with NNs include specialized NN processing units, such as tensor processing units (TPUs) and Field Programmable Gate Arrays (FPGAs) programmed to accelerate neural network processing. Such hardware devices are being deployed in consumer devices as well as in data centers due to their flexible nature and low power consumption per unit computation.

Traditionally NNs have been trained and deployed using single-precision floating-point (32-bit floating-point or float32 format). However, it has been shown that lower precision floating-point formats, such as 16-bit floating-point (float16) or fixed-point can be used to perform inference operations with minimal loss in accuracy. On specialized hardware, such as FPGAs, reduced precision formats can greatly improve the latency and throughput of DNN processing.

Numbers represented in normal-precision floating-point format (e.g., a floating-point number expressed in a 16-bit floating-point format, a 32-bit floating-point format, a 64-bit floating-point format, or an 80-bit floating-point format, alternatively referred to herein as a standard-precision floating-point format), can be converted to quantized-precision format numbers may allow for performance benefits in performing operations. In particular, NN weights and activation values can be represented in a lower-precision quantized format with an acceptable level of error introduced. Examples of lower-precision quantized formats include formats having a reduced bit width (including by reducing the number of bits used to represent a number's mantissa or exponent) and block floating-point formats where two or more numbers share the same single exponent.

One of the characteristics of computation on an FPGA device is that it typically lacks hardware floating-point support. Floating-point operations may be performed at a penalty using the flexible logic, but often the amount of logic needed to support floating-point is prohibitive in FPGA implementations. Some newer FPGAs have been developed that do support floating-point computation, but even on these the same device can produce twice as many computational outputs per unit time as when it is used in an integer mode. Typically, NNs are created with floating-point computation in mind, but when an FPGA is targeted for NN processing it would be beneficial if the neural network could be expressed using integer arithmetic. Examples of the disclosed technology include hardware implementations of block floating-point (BFP), including the use of BFP in NN, FPGA, and other hardware environments.

Neural network operations are used in many artificial intelligence operations. Often, the bulk of the processing operations performed in implementing a neural network is in performing Matrix $\times$ Matrix or Matrix $\times$ Vector multiplications. Such operations are compute- and memory-bandwidth intensive, where the size of a matrix may be, for example, 1000 $\times$ 1000 elements (e.g., 1000 $\times$ 1000 numbers, each including a sign, mantissa, and exponent) or larger and there are many matrices used. As discussed herein, BFP techniques can be applied to such operations to reduce the demands for computation as well as memory bandwidth in a given system, whether it is an FPGA, CPU or another hardware platform. As used herein, the use of the term "element" herein refers to a member of such a matrix or vector.

As used herein, the term "tensor" refers to a multi-dimensional array that can be used to represent properties of a NN and includes one-dimensional vectors as well as two-, three-, four-, or larger dimension matrices. As used in this disclosure, tensors do not require any other mathematical properties unless specifically stated.

As used herein, the term "normal-precision floating-point" refers to a floating-point number format having a mantissa, exponent, and optionally a sign and which is natively supported by a native or virtual CPU. Examples of normal-precision floating-point formats include, but are not limited to, IEEE 754 standard formats such as 16-bit, 32-bit, 64-bit, or to other processors supported by a processor, such as Intel AVX, AVX2, IA32, and x86_64 80-bit floating-point formats.

As used herein, the term "quantized-precision floating-point" refers to a floating-point number format where two or more values of a tensor have been modified to emulate neural network hardware. In particular, many examples of quantized-precision floating-point representations include block floating-point formats, where two or more values of the tensor are represented with reference to a common exponent. The quantized-precision floating-point number can be generated by selecting a common exponent for two, more, or all elements of a tensor and shifting mantissas of individual elements to match the shared, common exponent. In some examples, groups of elements within a tensor can share a common exponent on, for example, a per-row, per-column, per-tile, or other basis.

## III. Introduction to the Disclosed Technology

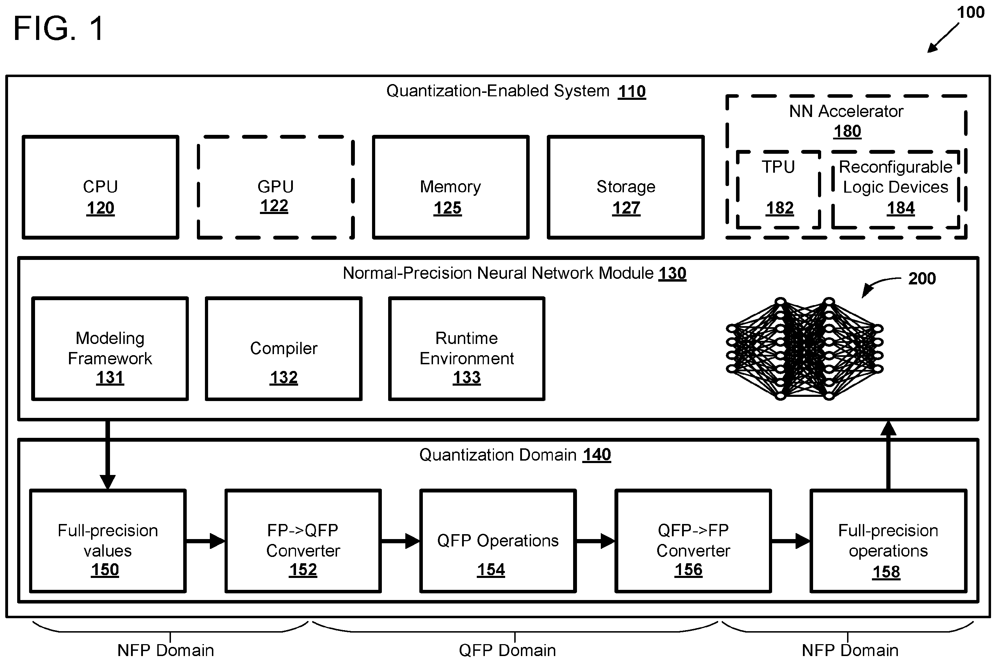

FIG. 1 is a block diagram 100 outlining an example quantization-enabled system 110 as can be implemented certain examples of the disclosed technology. As shown in FIG. 1, the quantization-enabled system 110 can include a number of hardware resources including general-purpose processors 120 and special-purpose processors such as graphics processing units 122. The processors are coupled to memory 125 and storage 127, which can include volatile or non-volatile memory devices. The processors 120 and 122 execute instructions stored in the memory or storage in order to provide a normal-precision neural network module 130. The normal-precision neural network module 130 includes software interfaces that allow the system to be programmed to implement various types of neural networks. For example, software functions can be provided that allow applications to define neural networks including weights, activation values, and interconnections between layers of a neural network. The normal-precision neural network module 130 can further provide utilities to allow for training and retraining of a neural network implemented with the module. Values representing the neural network module are stored in memory or storage and are operated on by instructions executed by one of the processors.

In some examples, proprietary or open source libraries or frameworks are provided to a programmer to implement neural network creation, training, and evaluation. Examples of such libraries include TensorFlow, Microsoft Cognitive Toolkit (CNTK), Caffe, Theano, and Keras. In some examples, programming tools such as integrated development environments provide support for programmers and users to define, compile, and evaluate NNs.

The quantization-enabled system 110 further includes a quantization domain 140. The quantization domain 140 provides functionality that can be used to convert data represented in full precision floating-point formats in the normal-precision neural network module 130 into quantized format values. In some examples, the quantization domain is implemented as a software emulator that models performing NN operations in a quantized format. In some examples, the quantization domain includes a hardware accelerator that can be used to accelerate inference and/or training operations in quantized precision number formats. In some examples, conversions to and from the quantization domain 140 can be performed in the normal-precision software domain, or by additional hardware in the quantization domain (as shown in FIG. 1). Such functionality will be discussed in further detail below.

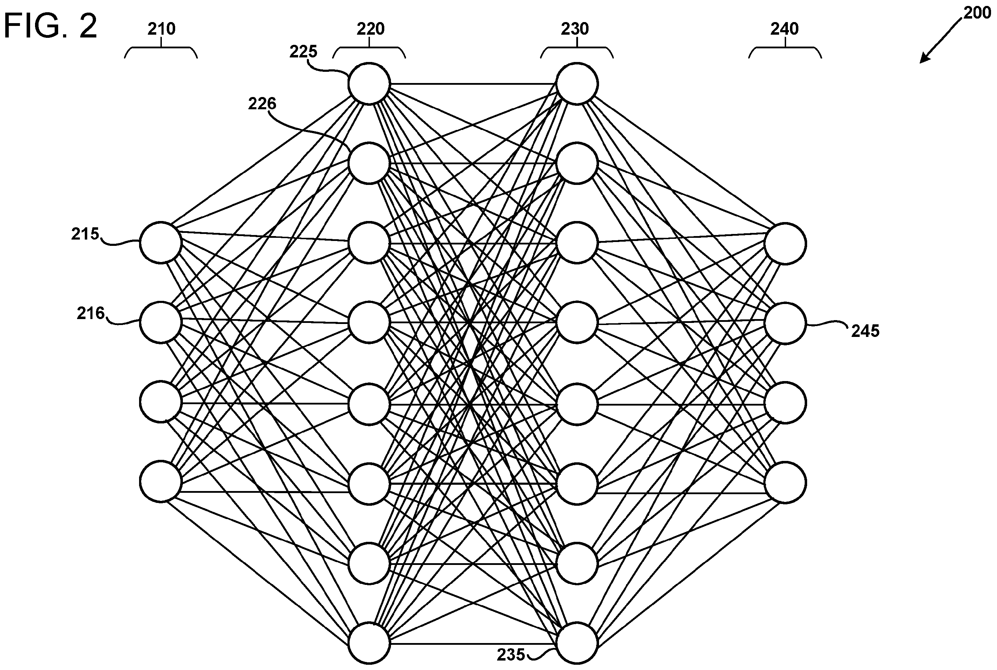

The normal-precision neural network module 130 can be used to specify, train, and evaluate a neural network model using a tool flow that includes a hardware-agnostic modelling framework 131 (also referred to as a native framework or a machine learning execution engine), a neural network compiler 132, and a neural network runtime environment 133. The memory includes computer-executable instructions for the tool flow including the modelling framework 131, the neural network compiler 132, and the neural network runtime environment 133. The tool flow can be used to generate neural network data 200 representing all or a portion of the neural network model, such as the neural network model discussed below regarding FIG. 2. It should be noted that while the tool flow is described as having three separate tools (131, 132, and 133), the tool flow can have fewer or more tools in various examples. For example, the functions of the different tools (131, 132, and 133) can be combined into a single modelling and execution environment.

The neural network data 200 can be stored in the memory 125. The neural network data 200 can be represented in one or more formats. For example, the neural network data 200 corresponding to a given neural network model can have a different format associated with each respective tool of the tool flow. Generally, the neural network data 200 can include a description of nodes, edges, groupings, weights, biases, activation functions, and/or tensor values. As a specific example, the neural network data 200 can include source code, executable code, metadata, configuration data, data structures and/or files for representing the neural network model.

The modelling framework 131 can be used to define and use a neural network model. As one example, the modelling framework 131 can include pre-defined APIs and/or programming primitives that can be used to specify one or more aspects of the neural network model. The pre-defined APIs can include both lower-level APIs (*e.g.,* activation functions, cost or error functions, nodes, edges, and tensors) and higher-level APIs (e.g., layers, convolutional neural networks, recurrent neural networks, linear classifiers, and so forth). "Source code" can be used as an input to the modelling framework 131 to define a topology of the graph of a given neural network model. In particular, APIs of the modelling framework 131 can be instantiated and interconnected within the source code to specify a complex neural network model. A data scientist can create different neural network models by using different APIs, different numbers of APIs, and interconnecting the APIs in different ways.

In addition to the source code, the memory 125 can also store training data. The training data includes a set of input data for applying to the neural network model 200 and a desired output from the neural network model for each respective dataset of the input data. The modelling framework 131 can be used to train the neural network model with the training data. An output of the training is the weights and biases that are associated with each node of the neural network model. After the neural network model is trained, the modelling framework 131 can be used to classify new data that is applied to the trained neural network model. Specifically, the trained neural network model uses the weights and biases obtained from training to perform classification and recognition tasks on data that has not been used to train the neural network model. The modelling framework 131 generally uses only the CPU 120 to execute the neural network model and so it may not achieve real-time performance for some classification tasks. The modelling framework 131 may also support using a GPU 122 to execute the neural network model, but the performance may still not reach real-time performance.

The compiler 132 analyzes the source code and data (*e.g.,* the weights and biases learned from training the model) provided for a neural network model and transforms the model into a format that can be accelerated in the quantization domain 140 and/or an optional neural network accelerator 180, which will be described in further detail below. Specifically, the compiler 132 transforms the source code into executable code, metadata, configuration data, and/or data structures for representing the neural network model and memory as neural network data 200. In some examples, the compiler 132 can divide the neural network model into portions (*e.g.*, neural network 200) using the CPU 120 and/or the GPU 122) and other portions (*e.g.,* a neural network subgraph) that can be executed on the neural network accelerator 180. The compiler 132 can generate executable code (*e.g.,* runtime modules) for executing subgraphs assigned to the CPU 120 and for communicating with the subgraphs assigned to the optional accelerator 180. The compiler 132 can generate configuration data for the accelerator 180 that is used to configure accelerator resources to evaluate the subgraphs assigned to the optional accelerator 180. The compiler 132 can create data structures for storing values generated by the neural network model during execution and/or training and for communication between the CPU 120 and the accelerator 180. The compiler 132 can generate metadata that can be used to identify subgraphs, edge groupings, training data, and various other information about the neural network model during runtime. For example, the metadata can include information for interfacing between the different subgraphs of the neural network model.

The runtime environment 133 provides an executable environment or an interpreter that can be used to train the neural network model during a training mode and that can be used to evaluate the neural network model in training, inference, or classification modes. During the inference mode, input data can be applied to the neural network model inputs and the input data can be classified in accordance with the training of the neural network model. The input data can be archived data or real-time data.

The runtime environment 133 can include a deployment tool that, during a deployment mode, can be used to deploy or install all or a portion of the neural network to the quantization domain 140. The runtime environment 133 can further include a scheduler that manages the execution of the different runtime modules and the communication between the runtime modules and the quantization domain 140. Thus, the runtime environment 133 can be used to control the flow of data between nodes modeled on the normal-precision neural network module 130 and the quantization domain 140.

The quantization domain 140 receives normal-precision values 150 from the normal-precision neural network module 130. The normal-precision values can be represented in 16-, 32-, 64-bit, or another suitable floating-point format. For example, a portion of values representing the neural network can be received, including edge weights, activation values, or other suitable parameters for quantization. The normal-precision values 150 are provided to a normal-precision floating-point to quantized floating-point converter 152, which converts the normal-precision value into quantized values. Quantized floating-point operations 154 can then be performed on the quantized values. The quantized values can then be converted back to a normal-floating-point format using a quantized floating-point to normal-floating-point converter which produces normal-precision floating-point values.

The conversions between normal floating-point and quantized floating-point performed by the converters 152 and 156 are typically performed on sets of numbers represented as vectors or multi-dimensional matrices. In some examples, additional normal-precision operations 158, including operations that may be desirable in particular neural network implementations can be performed based on normal-precision formats including adding a bias to one or more nodes of a neural network, applying a hyperbolic tangent function or other such sigmoid function, or rectification functions (e.g., ReLU operations) to normal-precision values that are converted back from the quantized floating-point format.

In some examples, the quantized values are actually stored in memory as normal floating-point values. In other words, the quantization domain 140 quantizes the inputs, weights, and activations for a neural network model, but the underlying operations are performed in normal floating-point. In other examples, the quantization domain provides full emulation of quantization, including only storing one copy of the shared exponent and operating with reduced mantissa widths. Some results may differ over versions where the underlying operations are performed in normal floating-point. For example, the full emulation version can check for underflow or overflow conditions for a limited, quantized bit width (e.g., 3, 4, or 5 bit wide mantissas).

The bulk of the computational cost of DNNs is in matrix-vector and matrix-matrix multiplications. These operations are quadratic in input sizes while operations such as bias add and activation functions are linear in input size. Thus, in some examples, quantization is only applied to matrix-vector multiplication operations, which will be eventually implemented on a NN hardware accelerator, such as a TPU or FPGA. In such examples, all other operations are done in a normal-precision format, such as float16. Thus, from the user or programmer's perspective, the quantization-enabled system 110 accepts and outputs normal-precision float16 values from/to the normal-precision neural network module 130 and output float16 format values. All conversions to and from block floating-point format can be hidden from the programmer or user. In some examples, the programmer or user may specify certain parameters for quantization operations. In other examples, quantization operations can take advantage of block floating-point format to reduce computation complexity.

In certain examples, an optional neural network accelerator 180 is used to accelerate evaluation and/or training of neural network subgraphs, typically with increased speed and reduced latency that is not realized when evaluating the subgraph only in the quantization domain 140. In the illustrated example, the accelerator includes a Tensor Processing Unit 182 and/or reconfigurable logic devices 184 (e.g., contained in one or more FPGAs or a programmable circuit fabric), however any suitable hardware accelerator can be used that models neural networks. The accelerator 180 can include configuration logic which provides a soft CPU. The soft CPU supervises operation of the accelerated subgraph on the accelerator 180 and can manage communications with the normal-precision neural network module 130 and/or the quantization domain 140. The soft CPU can also be used to configure logic and to control loading and storing of data from RAM on the accelerator, for example in block RAM within an FPGA.

In some examples, the quantization domain 140 is used to prototype training, inference, or classification of all or a portion of the neural network model 200. For example, quantization parameters can be selected based on accuracy or performance results obtained by prototyping the network within quantization domain 140. After a desired set of quantization parameters is selected, a quantized model can be programmed into the accelerator 180 for performing further operations. In some examples, the final quantized model implemented with the quantization domain 140 is identical to the quantized model that will be programmed into the accelerator 180. In other examples, the model programmed into the accelerator may be different in certain respects.

The compiler 132 and the runtime 133 provide a fast interface between the normal-precision neural network module 130, the quantization domain 140, and (optionally) the accelerator 180. In effect, the user of the neural network model may be unaware that a portion of the model is being accelerated on the provided accelerator. For example, node values are typically propagated in a model by writing tensor values to a data structure including an identifier. The runtime 133 associates subgraph identifiers with the accelerator, and provides logic for translating the message to the accelerator, transparently writing values for weights, biases, and/or tensors to the quantization domain 140, and/or (optionally) the accelerator 180, without program intervention. Similarly, values that are output by the quantization domain 140, and (optionally) the accelerator 180 may be transparently sent back to the normal-precision neural network module 130 with a message including an identifier of a receiving node at the server and a payload that includes values such as weights, biases, and/or tensors that are sent back to the overall neural network model.

## IV. Example Deep Neural Network Topology

FIG. 2 illustrates a simplified topology of a deep neural network (DNN) 200 that can be used to perform enhanced image processing. One or more processing layers can be implemented using quantized and BFP matrix/vector operations, including the use of one or more of the plurality 210 of neural network cores in the quantization-enabled system 110 described above. It should be noted that applications of the neural network implementations disclosed herein are not limited to DNNs but can also be used with other types of neural networks, such as convolutional neural networks (CNNs), including implementations having Long Short Term Memory (LSTMs) or gated recurrent units (GRUs), or other suitable artificial neural networks that can be adapted to use BFP methods and apparatus disclosed herein.

As shown in FIG. 2, a first set 210 of nodes (including nodes 215 and 216) form an input layer. Each node of the set 210 is connected to each node in a first hidden layer formed from a second set 220 of nodes (including nodes 225 and 226). A second hidden layer is formed from a third set 230 of nodes, including node 235. An output layer is formed from a fourth set 240 of nodes (including node 245). In example 200, the nodes of a given layer are fully interconnected to the nodes of its neighboring layer(s). In other words, a layer can include nodes that have common inputs with the other nodes of the layer and/or provide outputs to common destinations of the other nodes of the layer. In other examples, a layer can include nodes that have a subset of common inputs with the other nodes of the layer and/or provide outputs to a subset of common destinations of the other nodes of the layer.

Each of the nodes produces an output by applying a weight to each input generated from the preceding node and collecting the weights to produce an output value. In some examples, each individual node can have an activation function and/or a bias applied. For example, any appropriately programmed processor or FPGA can be configured to implement the nodes in the depicted neural network 200. In some example neural networks, an activation function $f(\ )$ of a hidden combinational node $n$ can produce an output expressed mathematically as:

$$f(n) = \sum_{i=0} w_i x_i + b_i$$

where $w_i$ is a weight that is applied (multiplied) to an input edge $x_i$, plus a bias value $b_i$. In some examples, the activation function produces a continuous value (represented as a floating-point number) between 0 and 1. In some examples, the activation function produces a binary 1 or 0 value, depending on whether the summation is above or below a threshold.

Neural networks can be trained and retrained by adjusting constituent values of the activation function. For example, by adjusting weights $w_i$ or bias values $b_i$ for a node, the behavior of the neural network is adjusted by corresponding changes in the networks output tensor values. For example, a cost function C(w, b) can be used to find suitable weights and biases for the network and described mathematically as:

$$C(w,b) = \frac{1}{2n} \sum_x \|y(x) - a\|^2$$

where $w$ and $b$ represent all weights and biases, n is the number of training inputs, $a$ is a vector of output values from the network for an input vector of training inputs $x$. By adjusting the network weights and biases, the cost function $C$ can be driven to a goal value (*e.g.,* to zero (0)) using various search techniques, for examples, stochastic gradient descent.

In techniques such as stochastic gradient descent, various parameters can be adjusted to tune the performance of the NN during training. These parameters, which are referred to herein as "hyper-parameters," include a learning rate parameter which influences the rate at which the cost function $C$ is driven to a goal value. As discussed further below, hyper-parameters such as the learning rate can be adjusted to compensate for noise introduced by quantization of NN parameters. Such adjustments can enable training of a quantized NN with the same or better accuracy as compared a non-quantized NN. Further, such adjustments can enable faster convergence of the cost function $C$ to the goal value (e.g., convergence after fewer training epochs).

According to certain aspects of the disclosed technology, performance of NN training and inference can be improved. For example, by using certain disclosed examples of adjusting learning rates based on at least one noise-to-signal metric, training of quantized NNs can be achieved faster, using less memory, and/or with higher accuracy, depending on the particular example, despite the noise introduced by quantization. In particular, by reducing the amount of time spent training, including back propagation, the duration of any particular training epoch can be reduced. Further, by using certain disclosed examples of adjusting learning rates, the number of training epochs can be reduced.

Suitable applications for such neural network BFP implementations include performing image recognition, performing speech recognition, classifying images, translating speech to text and/or to other languages, facial or other biometric recognition, natural language processing, automated language translation, query processing in search engines, automatic content selection, analyzing email and other electronic documents, In alternative examples, further applications include relationship management, biomedical informatics, identifying candidate biomolecules . providing recommendations, or other classification and artificial intelligence tasks.

In some examples, a set of parallel multiply-accumulate (MAC) units in each convolutional layer can be used to speed up the computation. Also, parallel multiplier units can be used in the fully-connected and dense-matrix multiplication stages. A parallel set of classifiers can also be used. Such parallelization methods have the potential to speed up the computation even further at the cost of added control complexity.

As will be readily understood to one of ordinary skill in the art having the benefit of the present disclosure, the application of neural network implementations can be used for different aspects of using neural networks, whether alone or in combination or subcombination with one another. For example, disclosed implementations can be used to implement neural network training via gradient descent and/or back-propagation operations for a neural network.

## V. Example Method of Scaling the Learning Rate

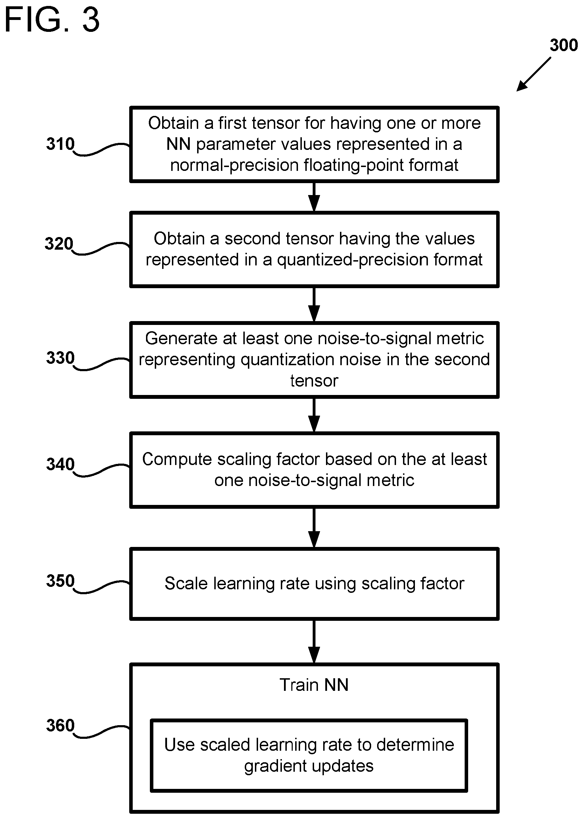

FIG. 3 is a flowchart 300 outlining an example method of scaling a learning rate for training a NN (e.g., a DNN) in a quantization-enabled system, as can be used in certain examples of the disclosed technology. For example, the system of FIG. 1 can be used to implement the illustrated method in conjunction with the DNN topology shown in FIG. 2.

At process block 310, a first tensor having one or more NN parameter values represented in a normal-precision floating-point format is obtained. The first tensor can include values of one or more, or all, of the parameters of one or more layers of the NN. For example, this can include values of activation weights, edge weights, etc. The first tensor can take the form of a matrix, for example.

At process block 320, a second tensor for the NN is obtained, the second tensor having the same values as the first tensor but with the values represented in a quantized-precision format, which introduces noise. In some examples, the second tensor is obtained by converting (e.g., by a processor) the values of the first tensor to the quantized-precision format. The quantized-precision format can be a format in which the bit width selected to represent exponents or mantissas is adjusted relative to the normal-precision floating-point format. Alternatively, the quantized-precision format can be a block floating-point format. The same quantized-precision format can be used for all parameters of the NN. In other examples, however, different quantized-precision formats can be used for different parameters within the NN.

At process block 330, at least one noise-to-signal metric for the NN is generated. For example, the at least one noise-to-signal metric can include one more noise-to-signal ratios. In such an example, as discussed further in Section VI below, a quantization noise-to-signal ratio $\frac{\xi^{(l)}}{x^{(l)}}$ for activation weights $X$ of a layer $l$ of the NN can be computed by first computing a difference $\xi^{(l)}$ between the (quantized) activation weights of the second tensor and of the (non-quantized) activation weights of the first tensor, where $\xi^{(l)}$ represents quantization noise in the quantized activation weights, and then dividing the difference $\xi^{(l)}$ by the absolute value of the activation weights of the first tensor. The activation weights $X$ of layer $l$ can be represented as a vector, in which case the difference and the ratio $\frac{\xi^{(l)}}{x^{(l)}}$ can also be represented as vectors.

Additionally, a quantization noise-to-signal ratio $\frac{\gamma^{(k)}}{w^{(k)}}$ for the edge weights w of each of a plurality of layers $k$ can also be computed by computing a difference $\gamma^{(k)}$ between the (quantized) edge weights of the second tensor and the (non-quantized) edge weights of the first tensor, where $\gamma^{(k)}$ represents quantization noise in the quantized edge weights, and dividing the difference by the absolute value of the edge weights of the first tensor. The edge weights $\gamma$ of layer $k$ can be represented as a matrix, in which case the difference $\gamma^{(k)}$ and the ratio $\frac{\gamma^{(k)}}{w^{(k)}}$ can also be represented as matrices. In some examples, the at least one noise-to-signal metric includes quantization noise-to-signal ratios for the layer following layer $l$ (e.g., layer $l + 1$) as well as for all other layers of the NN following layer $l + 1$.

Other noise-to-signal metrics can also be computed at process block 330 without departing from the scope of the appended claims. For example, a noise-to-signal ratio for any quantized parameter of the NN, or for any vector or matrix of quantized parameters of the NN, can be computed.

At process block 340, a scaling factor is computed based on the at least one noise-to-signal metric. For example, as discussed further in Section VI below, a scaling factor g can be computed by the following equation in the context of a DNN:

$$g = \frac{1}{1 + \mathrm{E}\left[\frac{\xi^{(l)}}{w^{(l)}}\right] + \sum_{k=l+1}^{L} E\left[\frac{\gamma^{(k)}}{w^{(k)}}\right]},$$

where

$$\mathrm{E}\left[\frac{\xi^{(l)}}{\gamma^{(l)}}\right]$$

represents the average value of the noise-to-signal ratio vector for a layer $l$ of the NN over the batch size as well as the elements of the tensor,

$$E\left[\frac{\gamma^{(k)}}{w^{(k)}}\right]$$

represents the average value of the noise-to-signal ratio over the elements of the tensor per sample, and

$$\sum_{k=l+1}^{L} E\left[\frac{\gamma^{(k)}}{w^{(k)}}\right]$$

represents the sum of the average values

$$E\left[\frac{\gamma^{(k)}}{w^{(k)}}\right]$$

for layers $l + 1$ through $L$ of the NN (e.g., all layers following layer $l$ in the NN). This formulation accounts for the first-order approximation of the noise to signal ratio and can be modified to include higher-order noise levels when required. Alternatively, the scaling factor g can be computed by a different equation (e.g., Eq. (34) set forth in Section VII below) in the context of an RNN.

At process block 350, a learning rate for the NN is scaled, using the scaling factor computed at process block 340. The learning rate that is scaled can be a predetermined learning rate for the NN (e.g., a "global" learning rate used to compute gradient updates for all layers of the NN during a back-propagation phase of training). For example, as discussed further below in Section VI, the scaled learning rate can be computed as the product of the scaling factor and the predetermined learning rate for the neural network. The scaled learning rate can be different for each layer of the neural network.

At process block 360, the NN is trained. This can include performing one or more epochs of training. In some examples, the training can continue until convergence of the NN outputs is achieved. Stochastic gradient descent training is an example of a suitable technique that can be used to train the NN; however, other techniques can be used to train the NN without departing from the scope of the appended claims.

As shown, training the quantized NN at process block 360 includes using the scaled learning rate (e.g., as determined at process block 350) to determine gradient updates. The gradient updates can be applied to one or more parameters (e.g., weights) of one or more layers of the NN. In some examples, the scaling factor computed at 340 is for a single layer of the NN, and is used to determine gradient updates only for parameters of that layer. In other examples, however, the scaling factor computed for a single layer can be used to determine gradient updates for parameters of other layers as well (e.g., for every layer of the NN).

Alternatively, the scaled learning rate can be used to determine gradient updates for only those parameters of the NN whose values have the same quantized-precision format as the values of the parameters used to compute the at least one noise-to-signal metric at process block 330. Experimental results have shown that the variance of noise-to-signal ratios computed in accordance with the present disclosure is low for parameters having the same quantized-precision format (e.g., the same bit width). Accordingly, scaling factors computed in accordance with the present disclosure for different quantized-precision formats and NN architecture/topology can be stored in memory, such as in a lookup table. In such examples, determining a gradient update for a given NN parameter can include accessing an entry in the lookup table corresponding to a particular quantized-precision format (e.g., bit width) of that parameter, or of the parameters of that layer, to obtain a scaling factor that was previously determined for that format.

Scaling the learning rate used to determine gradient updates during training of a NN can advantageously improve the accuracy of the training results. For example, the experimental results discussed in Section X below show that the accuracy of training results for quantized NNs can be improved to match, or even exceed, the accuracy achieved when training an equivalent non-quantized NN. Accordingly, scaling the learning rate in accordance with the method of FIG. 3 can facilitate the use of lower-precision quantized formats in training NNs, and thereby improve the efficiency of the hardware implementing the training.

## VI. <u>Computing an Adjusted Learning Rate for a DNN</u>

The theoretical basis for the computations discussed in Section V above will be described in this section for a DNN model with $L$ layers. In such a model, the gradient update for a layer $l$ using stochastic gradient descent can be represented as follows:

$$\Delta \widetilde{w}^{(l)} = -\frac{\varepsilon_q}{N} \left( \frac{\partial \hat{C}}{\partial \widetilde{w}^{(l)}} + \frac{\partial C}{\partial \widetilde{w}^{(l)}} - \frac{\partial C}{\partial \widetilde{w}^{(l)}} \right) \qquad (1)$$

$$= -\frac{\varepsilon_q}{N} \left( \frac{\partial C}{\partial \widetilde{w}^{(l)}} + \underbrace{\left( \frac{\partial \hat{C}}{\partial \widetilde{w}^{(l)}} - \frac{\partial C}{\partial \widetilde{w}^{(l)}} \right)}_{gradient\ error\ \alpha} \right),$$

where $\varepsilon$ is the learning rate, $N$ is the total size of the training data set, $\frac{\partial C}{\partial \widetilde{w}^{(l)}}$ is the actual/true gradient update for layer $l$ with respect to the quantized weights, and $\frac{\partial \hat{C}}{\partial \widetilde{w}^{(l)}}$ is the estimated gradient update with respect to the quantized weights, evaluated on a mini-batch of size $B$. In particular,

$$\frac{\partial C}{\partial \widetilde{w}^{(l)}} = \sum_{i=1}^{N} \frac{\partial C_i}{\partial \widetilde{w}^{(l)}}, \text{ and } \frac{\partial \hat{C}_i}{\partial \widetilde{w}^{(l)}} = \frac{N}{B} \sum_{i=1}^{B} \frac{\partial C_i}{\partial \widetilde{w}^{(l)}}. \qquad (2)$$

Assuming that the underlying DNN model is designed based on the Rectified Linear unit (ReLU) as the non-linearity, the gradient update value for a hidden layer $l$ of a DNN can be computed as follows:

$$\frac{\partial C}{\partial \widetilde{w}^{(l)}} = \sum_{i=1}^{N} \frac{\partial C_i}{\partial \widetilde{w}^{(l)}},$$

$$= \sum_{i=1}^{N} \frac{\partial C_i}{\partial X_i^{(l+1)}} \frac{\partial X_i^{(l+1)}}{\partial \widetilde{w}^{(l)}}$$

$$\tag{3}$$

$$= \sum_{i=1}^{N} \frac{\partial C_i}{\partial X_i^{(l+1)}} \otimes \underbrace{\left( X_i^{(l)} + \xi_i^{(l)} \right)}_{quantized\ input\ to\ layer\ l}$$

$$= \sum_{i=1}^{N} \frac{\partial C_i}{\partial out_i} \frac{\partial out_i}{\partial out_i^{net}} \frac{\partial out_i^{net}}{\partial X_i^{(l+1)}} \otimes \left( X_i^{(l)} + \xi_i^{(l)} \right)$$

$$\approx \sum_{i=1}^{N} \left( \frac{\partial C_i}{\partial out_i^{net}} \prod_{j=l+1}^{L} \underbrace{(w^{(j)} + \gamma^{(j)})}_{quantized\ weights} \right)^{T} \left( X_i^{(l)} + \xi_i^{(l)} \right).$$

Here, $X_i^{(l)}$ is the activation vector in the layer $l$ for input sample $i$, $\xi_i^{(l)}$ is the noise induced in the activation vector due to quantization, $out_i$ represents the output of the DNN after the Softmax layer for input sample i, and $out_i^{net}$ represents the net values in the last layer before the Softmax layer. The notation $w^j$ indicates the weight matrix in layer $j$, and $\gamma^j$ is its corresponding quantization noise.

Similarly:

$$\frac{\partial \hat{C}}{\partial \widetilde{w}^{(l)}} = \frac{N}{B} \sum_{i=1}^{B} \frac{\partial C_i}{\partial \widetilde{w}^{(l)}} = \frac{N}{B} \sum_{i=1}^{B} \left( \frac{\partial C_i}{\partial out_i^{net}} \prod_{j=l+1}^{L} (w^j + \gamma^j) \right)^{T} \left( X_i^{(l)} + \xi_i^{(l)} \right). \tag{4}$$

Given that the gradient error $\alpha$ is defined as the difference between ( $\frac{\partial \hat{C}}{\partial \widetilde{w}^{(l)}} - \frac{\partial C}{\partial \widetilde{w}^{(l)}}$ ), the mean and variance of the gradient error can be computed as:

$$E[\alpha] = E\left[ \frac{\partial \hat{C}}{\partial \widetilde{w}^{(l)}} \right] - E\left[ \frac{\partial C}{\partial \widetilde{w}^{(l)}} \right]$$

$$= \frac{N}{B} \Sigma_{i=1}^{B} E\left[ \frac{\partial C_i}{\partial \widetilde{w}^{(l)}} \right] - \Sigma_{i=1}^{N} E\left[ \frac{\partial C_i}{\partial \widetilde{w}^{(l)}} \right] \tag{5}$$

$$= \frac{N}{B} \times B \times E\left[ \frac{\partial C_i}{\partial \widetilde{w}^{(l)}} \right] - N \times E\left[ \frac{\partial C_i}{\partial \widetilde{w}^{(l)}} \right]$$

$$= 0.$$

The first step in the Eq. (5) is derived using the linearity property of the Expectation operation. The variance of the gradient noise is:

$$Var(\alpha) = E[\alpha^2] - E[\alpha]^2$$

$$= Var\left(\frac{\partial C}{\partial \widetilde{w}^{(l)}}\right) + Var\left(\frac{\partial \hat{C}}{\partial \widetilde{w}^{(l)}}\right) - 2\,Cov\left(\frac{\partial \hat{C}}{\partial \widetilde{w}^{(l)}}, \frac{\partial C}{\partial \widetilde{w}^{(l)}}\right). \tag{6}$$

Each of the terms in Eq. (6) can be computed as the following:

$$Var\left(\frac{\partial C}{\partial \widetilde{w}^{(l)}}\right) = Var\left(\sum_{i=1}^{N}\left(\frac{\partial C_i}{\partial out_i^{net}}\prod_{j=l+1}^{L}\left(w^{(j)} + \gamma^{(j)}\right)\right)^T\left(X_i^{(l)} + \xi_i^{(l)}\right)\right)$$

$$\approx Var\left(\left(\sum_{i=1}^{N}\left(\prod_{j=l+1}^{L} w^{(j)}\right)^T\left(\frac{\partial C_i}{\partial out_i^{net}}\right)^T X_i^{(l)}\right)\right.$$

$$+ \left(\sum_{i=1}^{N}\left(\prod_{j=l+1}^{L} w^{(j)}\right)^T\left(\frac{\partial C_i}{\partial out_i^{net}}\right)^T X_i^{(l)} \cdot E\left[\frac{\xi_i^{(l)}}{X_i^{(l)}}\right]\right)$$

$$+ \left.\left(\sum_{i=1}^{N}\left(\sum_{k=l+1}^{L} E\left[\frac{\gamma^{(k)}}{w^{(k)}}\right]\cdot\prod_{j=l+1}^{L} w^{(j)}\right)^T\left(\frac{\partial C_i}{\partial out_i^{net}}\right)^T X_i^{(l)}\right) + \lambda\right). \tag{7}$$

The term $\lambda$ in Eq. (7) can be ignored in a sense that it is a multiplication of $\gamma$ and $\xi$ values and is orders of magnitude less than the other terms. In Eq. (7), the quantization noise to signal ratio vector and matrix ($\frac{\xi_i^{(l)}}{X_i^{(l)}}$ and $\frac{\gamma^{(l)}}{w^{(l)}}$) are approximated by their corresponding expected value. As such:

$$Var\left(\frac{\partial C}{\partial \widetilde{w}^{(l)}}\right)$$

$$\approx Var\left(\sum_{i=1}^{N}\left(\underbrace{1 + E\left[\frac{\xi_i^{(l)}}{X_i^{(l)}}\right] + \sum_{k=l+1}^{L} E\left[\frac{\gamma^{(k)}}{w^{(k)}}\right]}_{quantization\ coefficient}\right)\left(\frac{\partial C_i}{\partial out_i^{net}}\prod_{j=l+1}^{L} w^{(j)}\right)^T X_i^{(l)}\right). \tag{8}$$

The value $E\left[\frac{\xi_i^{(l)}}{X_i^{(l)}}\right]$ denotes the average quantization noise to signal ratio in the $l^{th}$ layer activation for input sample $i$. This value is generally less than 1 and can be replaced by the expected value over samples; if the encoding approach is selected well the variance of $E\left[\frac{\xi_i^{(l)}}{X_i^{(l)}}\right]$ over different data samples i is much less than the variance of the other terms in the quantization coefficient in Eq. (8). Thereby,

$$Var\left(\frac{\partial C}{\partial \widetilde{w}^{(l)}}\right) \approx \left(1 + \mathbb{E}\left[\frac{\xi^{(l)}}{X^{(l)}}\right] + \sum_{k=l+1}^{L} E\left[\frac{\gamma^{(k)}}{w^{(k)}}\right]\right)^2 Var\left(\sum_{i=1}^{N}\left(\frac{\partial C_i}{\partial out_i^{net}} \prod_{j=l+1}^{L} w^{(j)}\right)^T X_i^{(l)}\right), \quad (9)$$

$$Var\left(\frac{\partial \hat{C}}{\partial \widetilde{w}^{(l)}}\right) \approx \left(1 + \mathbb{E}\left[\frac{\xi^{(l)}}{X^{(l)}}\right]\right) \quad (10)$$

$$+ \sum_{k=l+1}^{L} E\left[\frac{\gamma^{(k)}}{w^{(k)}}\right]\right)^2 Var\left(\frac{N}{B}\sum_{i=1}^{B}\left(\frac{\partial C_i}{\partial out_i^{net}} \prod_{j=l+1}^{L} w^{(j)}\right)^T X_i^{(l)}\right).$$

The matrix describing the average gradient covariances can be denoted by $F(w^{(l)})$, which is a function of the current parameter/weight values. In particular,

$$Cov\left(\frac{\partial C_i}{\partial w^{(l)}}, \frac{\partial C_j}{\partial w^{(l)}}\right) = F(w^{(l)})\delta_{ij}. \quad (11)$$

As such, it follows that:

$$Var\left(\frac{\partial C}{\partial \widetilde{w}^{(l)}}\right) \approx N\left(1 + \mathbb{E}\left[\frac{\xi^{(l)}}{X^{(l)}}\right] + \sum_{k=l+1}^{L} E\left[\frac{\gamma^{(k)}}{w^{(k)}}\right]\right)^2 F(w^{(l)}),$$

$$\quad (12)$$

$$Var\left(\frac{\partial \hat{C}}{\partial \widetilde{w}^{(l)}}\right) \approx B\left(\frac{N}{B}\right)^2 \left(1 + \mathbb{E}\left[\frac{\xi^{(l)}}{X^{(l)}}\right] + \sum_{k=l+1}^{L} E\left[\frac{\gamma^{(k)}}{w^{(k)}}\right]\right)^2 F(w^{(l)}).$$

Adopting the central limit theorem and modeling the gradient error $\alpha$ with Gaussian random noise, $Cov\left(\frac{\partial \hat{C}}{\partial \widetilde{w}^{(l)}}, \frac{\partial C}{\partial \widetilde{w}^{(l)}}\right)$ in Eq. (6) is equivalent to:

$$Cov\left(\frac{\partial \hat{C}}{\partial \widetilde{w}^{(l)}}, \frac{\partial C}{\partial \widetilde{w}^{(l)}}\right) \approx B\left(\frac{N}{B}\right)\left(1 + \mathbb{E}\left[\frac{\xi^{(l)}}{X^{(l)}}\right] + \sum_{k=l+1}^{L} E\left[\frac{\gamma^{(k)}}{w^{(k)}}\right]\right)^2 F(w^{(l)}). \quad (13)$$

Eq. (13) is approximated given that $Cov(aY,Z) = aCov(Y,Z)$, and given that for two partial sums of independent random variables ($Y_B$ and $Y_N$ where $B < N$), $Cov(Y_B, Y_N) = Cov(Y_B, Y_B + Y_N - Y_B) = Cov(Y_B, Y_B) + Cov(Y_B, Y_N - Y_B) = Var(Y_B)$. As such, the variance of the gradient noise in Eq. (6) is equivalent to:

$$Var(\alpha) \approx N\left(\frac{N}{B} - 1\right)\left(1 + \mathbb{E}\left[\frac{\xi^{(l)}}{X^{(l)}}\right] + \sum_{k=l+1}^{L} E\left[\frac{\gamma^{(k)}}{w^{(k)}}\right]\right)^2 F(w^{(l)}). \quad (14)$$

To continue, interpreting Eq. (1) as the discrete update of a stochastic differential equation yields:

$$\frac{\partial w^{(l)}}{\partial t} = \frac{\partial C}{\partial w^{(l)}} + \eta(t), \quad (15)$$

where $t$ is a continuous variable, $\eta(t)$ represents the gradient noise with an expected value of 0, and $E(\eta(t)\,(\eta(t')) = gF(w^{(l)})\,\delta(t-t')$. The constant $g$, alternatively referred to herein as the scaling factor, controls the scale of random fluctuations in the dynamics.

Eqs. 1 and 15 are related to one another in a sense that $\Delta w^{(l)} = \int_0^{\frac{\varepsilon}{N}} \frac{\partial w^{(l)}}{\partial t} dt = \frac{\varepsilon}{N} \frac{\partial C}{\partial w^{(l)}} + \int_0^{\frac{\varepsilon}{N}} \eta(t) dt$.
To keep the scaling factor g constant, the variance in this gradient update can be equated to the variance in Eq. (1), as follows:

$$\frac{\varepsilon_q^2}{N}\left(\frac{N}{B} - 1\right)\left(1 + E\left[\frac{\xi_i^{(l)}}{X_i^{(l)}}\right] + \sum_{k=l+1}^{L} \frac{\gamma^{(k)}}{w^{(k)}}\right)^2 \times F\left(w^{(l)}\right) = \frac{\varepsilon^2}{N}\left(\frac{N}{B} - 1\right) F\left(w^{(l)}\right) \qquad (16)$$

$$\varepsilon_q = \frac{\varepsilon}{1 + E\left[\frac{\xi^{(l)}}{X^{(l)}}\right] + \sum_{k=l+1}^{L} E\left[\frac{\gamma^{(k)}}{w^{(k)}}\right]}, \qquad (17)$$

Eq. (17) holds as long as the denominator stays positive.

VII. **Computing an Adjusted Learning Rate for a Recurrent Neural Network**

The theoretical basis for the computations discussed in Section V above will now be described in the context of a recurrent neural network (RNN). An RNN is a type of neural network composed of Long Short Term Memory (LSTM) units.
Considering a LSTM layer, the forward pass activations/states are computed as the following:

$$\textbf{Forget gate } f_t = \sigma\left(W_f.x_t + U_f.out_{t-1} + b_f\right),$$

$$\textbf{Input gate } I_t = \sigma(W_I.x_t + U_I.out_{t-1} + b_I),$$

$$\textbf{Input activation } a_t = tanh(W_a.x_t + U_a.out_{t-1} + b_a),$$

$$\textbf{Output gate } o_t = \sigma(W_o.x_t + U_o.out_{t-1} + b_o), \qquad (18)$$

$$\textbf{Internal state } state_t = a_t \odot I_t + f_t \odot state_{t-1},$$

$$\textbf{Output state } out_t = tanh(state_t) \odot o_t.$$

By defining the LSTM variables as $W = \begin{pmatrix} W_a \\ W_I \\ W_f \\ W_o \end{pmatrix}, gates_t = \begin{pmatrix} a_t \\ I_t \\ f_t \\ o_t \end{pmatrix}, U = \begin{pmatrix} U_a \\ U_I \\ U_f \\ U_o \end{pmatrix}$, and $b = \begin{pmatrix} b_a \\ b_I \\ b_f \\ b_o \end{pmatrix}$,
the backward pass gradients with respect to each variable can be computed as the following:

$$\partial out_t = \Delta T + \Delta out_t,$$

$$\partial state_t = \partial out_t \odot o_t \odot (1 - tanh^2(state_t)) + \partial state_{t+1} \odot f_{t+1},$$

$$\partial a_t = \partial state_t \odot I_t \odot (1 - a_t^2),$$

$$\partial I_t = \partial state_t \odot a_t \odot I_t \odot (1 - I_t),$$

$$\partial f_t = \partial state_t \odot state_{t-1} \odot f_t \odot (1 - f_t), \qquad (19)$$

$$\partial o_t = \partial out_t \odot tanh(state_t) \odot o_t \odot (1 - o_t),$$

$$\partial x_t = W^T \cdot \partial gates_t,$$

$$\Delta out_{t-1} = U^T \cdot \partial gates_t.$$

Here, $\Delta T$ is the output difference as computed by any subsequent layers.

The updates to the internal parameters can, in turn, be evaluated per:

$$\partial W = \Sigma_{t=0}^{T} \partial gates_t \otimes x_t,$$

$$\partial U = \Sigma_{t=0}^{T-1} \partial gates_{t+1} \otimes out_t, \qquad (20)$$

$$\partial b = \Sigma_{t=0}^{T} \partial gates_{t+1}.$$

The gradient update per set of weights using stochastic gradient descent can be represented as the following:

$$\Delta \widetilde{W} = -\frac{\varepsilon_q}{N} \left( \frac{\partial \hat{C}}{\partial \widetilde{W}} + \frac{\partial C}{\partial \widetilde{W}} - \frac{\partial C}{\partial \widetilde{W}} \right) \qquad (21)$$

$$= -\frac{\varepsilon_q}{N} \left( \frac{\partial C}{\partial \widetilde{W}} + \left( \frac{\partial \hat{C}}{\partial \widetilde{W}} - \frac{\partial C}{\partial \widetilde{W}} \right) \right),$$

where $\varepsilon_q$ is the learning rate, $N$ is the total size of the training data set, $\frac{\partial C}{\partial \widetilde{W}}$ is the actual/true gradient value with respect to the quantized weights, and $\frac{\partial \hat{C}}{\partial \widetilde{W}}$ is the estimated gradient evaluated on a mini-batch of size $B$. In particular,

$$\frac{\partial C}{\partial \widetilde{W}} = \sum_{i=1}^{N} \frac{\partial C_i}{\partial \widetilde{W}}, \text{ and}$$

$$\frac{\partial \hat{C}}{\partial \widetilde{W}} = \sum_{i=1}^{B} \frac{\partial C_i}{\partial \widetilde{W}}. \qquad (22)$$

As such, the gradient with respect to each weight matrix can be computed accordingly. For instance,

$$\frac{\partial C}{\partial W_a} = \sum_{i=1}^{N} \frac{\partial C_i}{\partial W_a}$$

$$= \sum_{i=1}^{N} \sum_{t=0}^{T} \left[ \frac{\partial C}{\partial state_t^i} \odot \tilde{l}_t^i \odot \left(1 - \hat{a}_t^{i2}\right) \right] \otimes \tilde{x}_t^i$$

$$= \sum_{i=1}^{N} \sum_{t=0}^{T} \left[ \left[ \underbrace{\frac{\partial C}{\partial \widetilde{out}_t^i}}_{A} \odot \underbrace{o_t^{-i}}_{B} \odot \underbrace{\left(1 - \tanh^2(\widetilde{state}_t^i)\right)}_{C} + \underbrace{\partial \widetilde{state}_{t+1}^i \odot f_{t+1}^i}_{D} \right] \odot \underbrace{\tilde{l}_t^i}_{E} \odot \underbrace{\left(1 - \hat{a}_t^{i2}\right)}_{F} \right] \otimes \underbrace{\tilde{x}_t^i}_{G} .$$

E: ... be computed as the following. To find a closed form solution, we have to stick to a set of assumptions: (i) the quantization noise on the output gate is absorbed in computing the loss value (e.g., $L_2$ difference); (ii) the variance of noise to signal ratio within a layer is relatively small compared to the corresponding mean value, and as such, the noise to signal ratio for each neuron/activation can be replaced by the corresponding mean value in that layer; (iii) the second order quantization noise is negligible; and (iv) the quantization noise (the difference between the quantized and float values) is small enough to lie within the linear region of *tanh.*

$$\mathbf{A} \mapsto \frac{\partial C}{\partial out_t^i}$$

$$\mathbf{B} \mapsto o_t^i + \epsilon_{o_t^i} \mapsto \left(1 + E\left[\frac{\epsilon_{o_t^i}}{o_t^i}\right]\right) \times o_t^i$$

$$\mathbf{C} \mapsto (1 - tanh^2(state_t^i + \epsilon_{state_t^i}))$$

$$\mapsto 1 - \left(\frac{tanh(state_t^i) + tanh(\epsilon_{state_t^i})}{1 + tanh(state_t^i) \times tanh(\epsilon_{state_t^i})}\right)^2 \tag{23}$$

$$\mapsto 1 - \left(\frac{tanh(state_t^i) + \epsilon_{state_t^i}}{1 + tanh(state_t^i) \times \epsilon_{state_t^i}}\right)^2$$

$$\mapsto 1 - \left(\frac{tanh^2(state_t^i) + \epsilon_{state_t^i}^2 + 2\,tanh(state_t^i)\epsilon_{state_t^i}}{1 + \epsilon_{state_t^i}^2 tanh^2(state_t^i) + 2\epsilon_{state_t^i}\,tanh(state_t^i)}\right)$$

$$\mapsto E\left[\frac{1 - \epsilon_{state_t^i}^2}{(1 + \epsilon_{state_t^i}\,tanh(state_t^i))^2}\right] \times \left(1 - tanh^2(state_t^i)\right)$$

$$\mathbf{H} \mapsto \underbrace{\left(1 + E[\frac{\epsilon_{o_t^i}}{o_t^i}]\right) \times E\left[\frac{(1 - \epsilon_{state_t^i}^2)}{(1 + \epsilon_{state_t^i}\,tanh(state_t^i))^2}\right]}_{\gamma} \times \frac{\partial C}{\partial out_t^i} \odot o_t^i \odot (1 - tanh^2(state_t^i))$$

$$\mathbf{D} \mapsto \gamma \times \partial state_{t+1}^i \odot \left(f_{t+1}^i + \epsilon_{f_{t+1}^i}\right)$$

$$\mapsto \gamma \times \left(1 + E[\frac{\epsilon_{f_{t+1}^i}}{o_{t+1}^i}]\right) \times \left(\partial state_{t+1}^i \odot f_{t+1}^i\right)$$

$$\mathbf{E} \mapsto I_t^i + \epsilon_{I_t^i} \mapsto I_t^i(1 + E\left[\frac{\epsilon_{I_t^i}}{I_t^i}\right])$$

$$\mathbf{F} \mapsto 1 - \left(a_t^i + \epsilon_{a_t^i}\right)^2 = 1 - a_t^{i2} - 2\epsilon_{a_t^i}a_t^i - \epsilon_{a_t^i}^2 \mapsto 1 - a_t^{i2}(1 + 2E[\frac{\epsilon_{a_t^i}}{a_t^i}])$$

$$\mathbf{G} \mapsto x_t^i + \epsilon_{x_t^i} \mapsto x_t^i\left(1 + E[\frac{\epsilon_{x_t^i}}{x_t^i}]\right)$$

With the first order assumption, the dominant factor is equivalent to:

$$E\left[\frac{1 - \epsilon_{state_t^i}^2}{\left(1 + \epsilon_{state_t^i}\,tanh(state_t^i)\right)^2}\right], \tag{24}$$

meaning that:

$$\frac{\partial C}{\partial \widetilde{W}_a} = E \underbrace{\left[\frac{1 - \epsilon^2_{state^i_t}}{(1 + \epsilon_{state^i_t} tanh(state^i_t))^2}\right]}_{\eta} \times \underbrace{\sum_{i=1}^{N} \frac{\partial C_i}{\partial W_a}}_{non-quantized\ variables} , \qquad (25)$$

where the mean value is computed over the number of data samples ($N$) and time stamp ($T$).

Given that the gradient error $\alpha$ is defined as the difference between ( $\frac{\partial \tilde{C}}{\partial \widetilde{W}_a} - \frac{\partial C}{\partial \widetilde{W}_a}$ ), the mean and variance of the gradient error can be computed as:

$$\begin{aligned} E[\alpha] &= E\left[\frac{\partial \tilde{C}}{\partial \widetilde{W}_a}\right] - E\left[\frac{\partial C}{\partial \widetilde{W}_a}\right] \\ &= \frac{N}{B}\Sigma^B_{i=1}E\left[\frac{\partial C_i}{\partial \widetilde{W}_a}\right] - \Sigma^N_{i=1}E\left[\frac{\partial C_i}{\partial \widetilde{W}_a}\right] \\ &= \frac{N}{B} \times B \times E\left[\frac{\partial C_i}{\partial \widetilde{W}_a}\right] - N \times E\left[\frac{\partial C_i}{\partial \widetilde{W}_a}\right] \\ &= 0. \end{aligned} \qquad (26)$$

The first step in Eq. (26) is derived using the linearity property of the Expectation operation. The variance of the gradient noise is:

$$\begin{aligned} Var(\alpha) &= E|\alpha^2| - E|\alpha|^2 \\ &= Var\left(\frac{\partial C}{\partial \widetilde{W}_a}\right) + Var\left(\frac{\partial \tilde{C}}{\partial \widetilde{W}_a}\right) - 2\,Cov\left(\frac{\partial \tilde{C}}{\partial \widetilde{W}_a}, \frac{\partial C}{\partial \widetilde{W}_a}\right). \end{aligned} \qquad (27)$$

The matrix describing the average gradient covariances can be denoted by $F(W_a)$, which is a function of the current parameter/weight values. In particular,

$$Cov\left(\frac{\partial C_i}{\partial W_a}, \frac{\partial C_j}{\partial W_a}\right) = F(W_a)\delta_{ij}. \qquad (28)$$

As such:

$$Var\left(\frac{\partial C}{\partial \widetilde{W}_a}\right) \approx N\,\eta^2 F(W_a), \qquad (29)$$

$$Var\left(\frac{\partial \tilde{C}}{\partial \widetilde{W}_a}\right) \approx B\left(\frac{N}{B}\right)^2 \eta^2 F(W_a).$$

Here, $\eta$ is defined per Eq. (25). By adopting the central limit theorem and modeling the gradient error $\alpha$ with Gaussian random noise, it follows that $Cov\left(\frac{\partial \tilde{C}}{\partial W_a}, \frac{\partial C}{\partial W_a}\right)$ in Eq. (27) is equivalent to:

$$Cov\left(\frac{\partial \tilde{C}}{\partial \widetilde{W}_a}, \frac{\partial C}{\partial \widetilde{W}_a}\right) \approx B\left(\frac{N}{B}\right)\eta^2 F(W_a). \qquad (30)$$

Eq. (30) is approximated given that $Cov(aY,Z) = aCov(Y,Z)$ and that for two partial sum of independent random variables ($Y_B$ and $Y_N$ where $B < N$), $Cov(Y_B,Y_N) = Cov(Y_B,Y_B + Y_N - Y_B) = Cov(Y_B,Y_B) + Cov(Y_B,Y_N - Y_B) = Var(Y_B)$. As such, the variance of the gradient noise in Eq. (27) is equivalent to:

$$Var(a) \approx N\left(\frac{N}{B} - 1\right)\eta^2 F(W_a). \qquad (31)$$

To continue, Eq. (18) can be interpreted as the discrete update of a stochastic differential equation as follows:

$$\frac{\partial W_a}{\partial t} = \frac{\partial C}{\partial W_a} + \beta(t), \qquad (32)$$

where t is a continuous variable, $\beta(t)$ is the gradient noise with an expected value of 0, and $E(\beta(t)\beta(t')) = gF(W_a)\,\delta(t - t')$. Here again, the constant g controls the scale of random fluctuations in the dynamics and is alternatively referred to as the scaling factor.

Eqs. (18) and (32) are related to one another in a sense that:

$$\Delta W_a = \int_0^{\frac{\varepsilon}{N}} \frac{\partial W_a}{\partial t}\, dt = \frac{\varepsilon}{N}\frac{\partial C}{\partial W_a} + \int_0^{\frac{\varepsilon}{N}} \beta(t)\, dt.$$

To keep the scaling factor g constant, the variance in this gradient update can be equated to the variance in Eq. (18).

$$\frac{\varepsilon_q^2}{N}\left(\frac{N}{B} - 1\right)\eta^2 \times F(W_a) = \frac{\varepsilon^2}{N}\left(\frac{N}{B} - 1\right)F(W_a) \qquad (33)$$

$$\varepsilon_q = \frac{\varepsilon}{E\left[\dfrac{1 - \epsilon_{state_t^i}^2}{(1 + \epsilon_{state_t^i}tanh(state_t^i))^2}\right]}. \qquad (34)$$

Here, $\varepsilon_q$ is the learning rate for quantized model and $\varepsilon$ is the learning rate used to train the float network. A similar approach can be applied to other parameters/weights in an LSTM layer.

## VIII. Compensating for Other Types of Noise

Methods similar to those described above can be used to compensate for any type of noise in a neural network that can be measured. For example, in addition to quantization noise, other types of noise can be introduced to neural networks for the sake of efficiency. This includes noise introduced by training the neural network in a low-voltage mode, e.g., a mode in which a voltage applied to hardware implementing the neural network is lower than a rated voltage for the hardware. As another example, a relatively lossy medium such as DRAM may be used to store parameters of the neural network during training, resulting in noise-inducing bit-flips. As yet another example, some parameter values of a neural network can be set equal to 0 or otherwise ignored, thereby introducing noise; this process is referred to as "pruning." Noise can also be introduced via block sparse training, in which selected parameter values of the neural network are pruned for one or more, but not all, epochs or iterations of training. As still another example, noise can be introduced by converting some or all parameters of the neural network to a different data type which does not have a lower bit width, as in quantization, but is noisier in another way. Alternatively, neural network training may be performed via an analog-based training system, which also introduces noise.

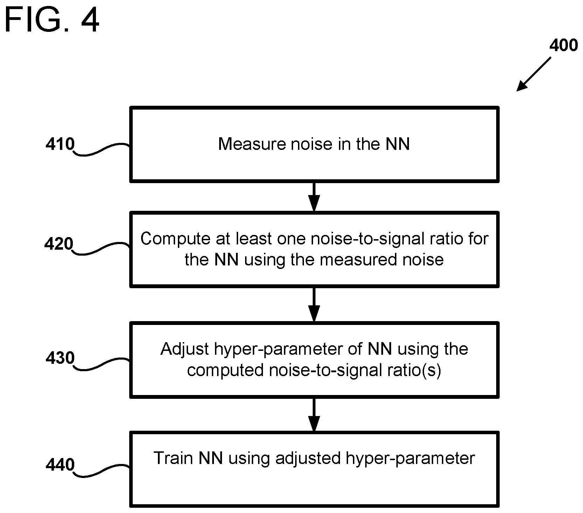

FIG. 4 is a flowchart 400 outlining an example method of adjusting a hyper-parameter to compensate for noise when training a NN, as can be used in certain examples of the disclosed technology. For example, the system of FIG. 1 can be used to implement the illustrated method.

At process block 410, noise in the NN is measured. The noise can be any type of noise related to the neural network that is measurable. For example, as discussed above with reference to FIG. 3, the noise measured can be quantization noise resulting from quantization of values of one or more parameters of the NN. As another example, the noise measured can be noise introduced by training the neural network in a low-voltage mode, noise introduced by storing parameters of the neural network in a relatively lossy medium such as DRAM during training, noise introduced by pruning or block sparse training, noise introduced by converting some or all parameters of the neural network to a non-quantized but otherwise noisy data type, noise introduced by using an analog-based training system for the NN, etc.

At process block 420, at least one noise-to-signal ratio is computed for the NN using the measured noise. In some examples, this can include obtaining a first set of values of one or more signals prior to introduction of the noise, obtaining a second set of values of the one or more signals after the introduction of noise, and computing a ratio of the difference between the first and second set of values to the first set of values.

At process block 430, a hyper-parameter of the NN is adjusted based on the noise-to-signal ratio computed at process block 420. As used herein, "hyper-parameters" refer to variables that determine the learning rate or structure of a neural network. For example, the hyper-parameter adjusted at process block 430 can be a learning rate, a learning rate schedule, a bias, a stochastic gradient descent batch size, a number of neurons in the neural network, a number of layers in the neural network, a sparsity level of the network, or a parameter related to privacy of the data (e.g., a differential privacy protocol), for example.

At process block 440, the NN is trained using the adjusted hyper-parameter. In examples in which the adjusted hyper-parameter is the learning rate, training the NN using the adjusted hyper-parameter can optionally include using the adjusted learning rate to compute gradient updates during back propagation. In examples in which the adjusted hyper-parameter is the learning rate schedule, training the NN using the adjusted hyper-parameter can optionally include compute gradient updates during back propagation in accordance with the adjusted learning rate schedule. In examples in which the adjusted hyper-parameter is the bias, training the NN using the adjusted hyper-parameter can optionally include using the adjusted bias to compute node outputs during forward propagation. In examples in which the adjusted hyper-parameter is the stochastic gradient descent batch size, training the NN using the adjusted hyper-parameter can optionally include increasing the stochastic gradient descent batch size as the noise-to-signal ratio increases. In examples in which the adjusted hyper-parameter is the number of neurons in the neural network, training the NN using the adjusted hyper-parameter can optionally include increasing the number of neurons in the neural network as the noise-to-signal ratio increases. In examples in which the adjusted hyper-parameter is the number of layers in the neural network, training the NN using the adjusted hyper-parameter can optionally include increasing the number of layers in the neural network as the noise-to-signal ratio increases. In other non-limiting examples, training the NN using the adjusted hyper-parameter can include using the adjusted hyper-parameter to compute values used during either forward propagation or back propagation.

## IX. Example Computing Environment

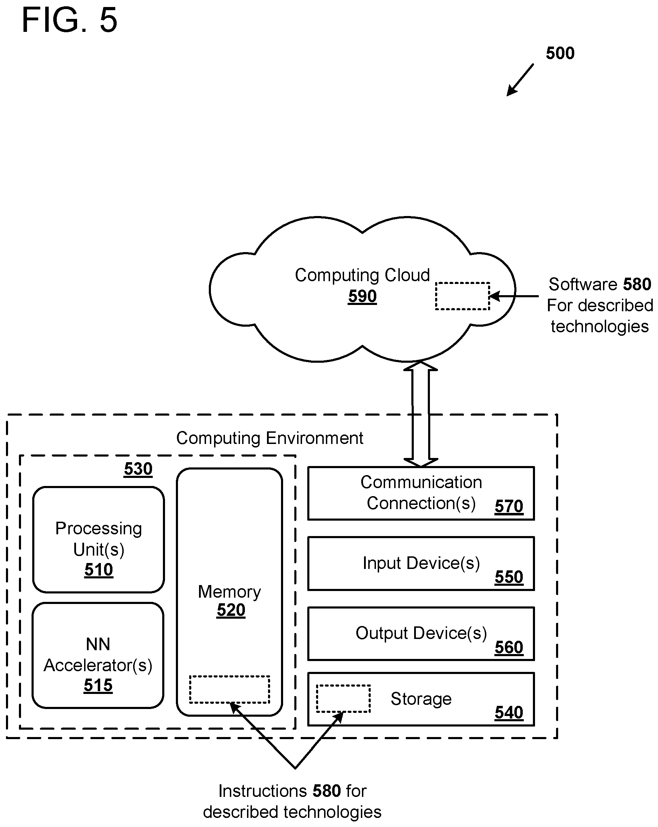

FIG. 5 illustrates a generalized example of a suitable computing environment 500 in which described embodiments, techniques, and technologies can be implemented. For example, the computing environment 500 can implement disclosed techniques for configuring a processor to implement disclosed software architectures and neural networks, and/or compile code into computer-executable instructions and/or configuration bitstreams for performing such operations including neural networks, as described herein.

The computing environment 500 is not intended to suggest any limitation as to scope of use or functionality of the technology, as the technology may be implemented in diverse general-purpose or special-purpose computing environments. For example, the disclosed technology may be implemented with other computer system configurations, including hand held devices, multi-processor systems, programmable consumer electronics, network PCs, minicomputers, mainframe computers, and the like. The disclosed technology may also be practiced in distributed computing environments where tasks are performed by remote processing devices that are linked through a communications network. In a distributed computing environment, program modules may be located in both local and remote memory storage devices.

With reference to FIG. 5, the computing environment 500 includes at least one processing unit 510, an optional neural network accelerator 515, and memory 520. In FIG. 5, this most basic configuration 530 is included within a dashed line. The processing unit 510 executes computer-executable instructions and may be a real or a virtual processor. In a multi-processing system, multiple processing units execute computer-executable instructions to increase processing power and as such, multiple processors can be running simultaneously. The accelerator 515 can include a Tensor Processing Unit (TPU) and/or reconfigurable logic devices, such as those contained in FPGAs or a programmable circuit fabric. The memory 520 may be volatile memory (*e.g.*, registers, cache, RAM), non-volatile memory (*e.g.,* ROM, EEPROM, flash memory, *etc.*), or some combination of the two. The memory 520 stores software 580, images, and video that can, for example, implement the technologies described herein. A computing environment may have additional features. For example, the computing environment 500 includes storage 540, one or more input device(s) 550, one or more output device(s) 560, and one or more communication connection(s) 570. An interconnection mechanism (not shown) such as a bus, a controller, or a network, interconnects the components of the computing environment 500. Typically, operating system software (not shown) provides an operating environment for other software executing in the computing environment 500, and coordinates activities of the components of the computing environment 500.

The storage 540 may be removable or non-removable, and includes magnetic disks, magnetic tapes or cassettes, CD-ROMs, CD-RWs, DVDs, or any other medium which can be used to store information and that can be accessed within the computing environment 500. The storage 540 stores instructions for the software 580, which can be used to implement technologies described herein.

The input device(s) 550 may be a touch input device, such as a keyboard, keypad, mouse, touch screen display, pen, or trackball, a voice input device, a scanning device, or another device, that provides input to the computing environment 500. For audio, the input device(s) 550 may be a sound card or similar device that accepts audio input in analog or digital form, or a CD-ROM reader that provides audio samples to the computing environment 500. The output device(s) 560 may be a display, printer, speaker, CD-writer, or another device that provides output from the computing environment 500.

The communication connection(s) 570 enable communication over a communication medium (*e.g.*, a connecting network) to another computing entity. The communication medium conveys information such as computer-executable instructions, compressed graphics information, video, or other data in a modulated data signal. The communication connection(s) 570 are not limited to wired connections (*e.g.*, megabit or gigabit Ethernet, Infiniband, Fibre Channel over electrical or fiber optic connections) but also include wireless technologies (*e.g.*, RF connections via Bluetooth, WiFi (IEEE 802.11a/b/n), WiMax, cellular, satellite, laser, infrared) and other suitable communication connections for providing a network connection for the disclosed methods. In a virtual host environment, the communication(s) connections can be a virtualized network connection provided by the virtual host.

Some embodiments of the disclosed methods can be performed using computer-executable instructions implementing all or a portion of the disclosed technology in a computing cloud 590. For example, disclosed compilers, processors, and/or neural networks are implemented with servers located in the computing environment, or the disclosed compilers, processors, and/or neural networks can be implemented on servers located in the computing cloud 590. In some examples, the disclosed compilers execute on traditional central processing units (*e.g.,* RISC or CISC processors), central processing units extended to include vector processing instructions, or vector processors.

Computer-readable media are any available media that can be accessed within a computing environment 500. By way of example, and not limitation, with the computing environment 500, computer-readable media include memory 520 and/or storage 540. As used herein, the term computer-readable storage media includes all tangible media for data storage such as memory 520 and storage 540, but not transmission media such as modulated data signals.

## X. <u>Experimental Results</u>

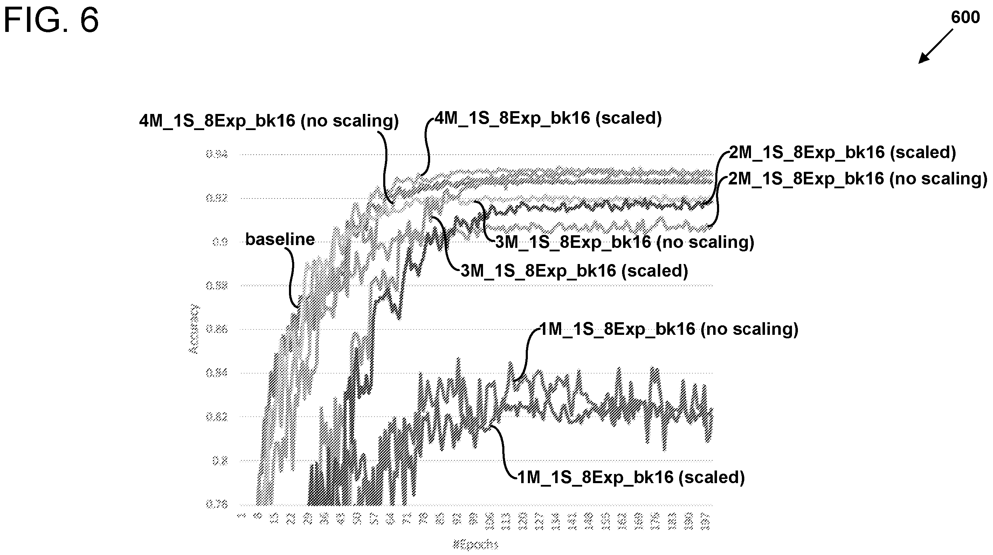

FIGS. 6-9 are a series of charts illustrating experimental results observed when training quantized neural networks, with and without learning rate scaling to compensate for quantization noise.

FIG. 6 is a chart 600 illustrating accuracy measured for a test neural network model using various levels of quantization, with and without learning rate scaling in accordance with the present disclosure. The test neural network model used in this experiment was a VGG-16 neural network having 16 layers, and the training was performed using CIFAR-10 data. In the baseline neural network, values of weights of the neural network were represented in a normal-precision float32 format. Results are charted for the baseline float32 model (represented by the plot labeled "baseline") as well as models with parameters in four different quantized-precision formats: an 8-bit shared exponent format with one mantissa bit and one sign bit (represented by the plots labeled "1M_1S_8Exp_bk16 (scaled)" and "1M_1S_8Exp_bk16 (no scaling)"); an 8-bit shared exponent format with two mantissa bits and one sign bit (represented by the plots labeled "2M_1S_8Exp_bk16 (scaled)" and "2M_1S_8Exp_bk16 (no scaling)"); an 8-bit shared exponent format with three mantissa bits and one sign bit (represented by the plots labeled "3M_1S_8Exp_bk16 (scaled)" and "3M_1S_8Exp_bk16 (no scaling)"); and an 8-bit shared exponent format with four mantissa bits and one sign bit (represented by the plots labeled "4M_1S_8Exp_bk16 (scaled)" and "4M_1S_8Exp_bk16 (no scaling)"). Other parameters of the experiment included batch normalization, with the gradients being quantized either before or after computing the average of each batch, and utilization of common deep learning libraries including PyTorch, TensorFlow, and Keras.

As shown, scaling the learning rate in the disclosed manner improves the accuracy of training compared to using the same learning rate as the baseline float32 model. For example, the accuracy achieved during training of the model quantized in the 8-bit shared exponent format with four mantissa bits and one sign bit is higher than the accuracy achieved by the baseline float32 model. Additionally, this quantized model converges more quickly than the baseline model, and thus fewer training epochs are required. As shown, similar improvements in accuracy and number of training epochs to convergence are achieved for other quantized formats when the learning rate is scaled in the disclosed manner. Accordingly, scaling the learning rate in the disclosed manner can advantageously improve the accuracy and efficiency of training of a quantized neural network, which in turn improves the operation of the computing hardware used to implement the training.

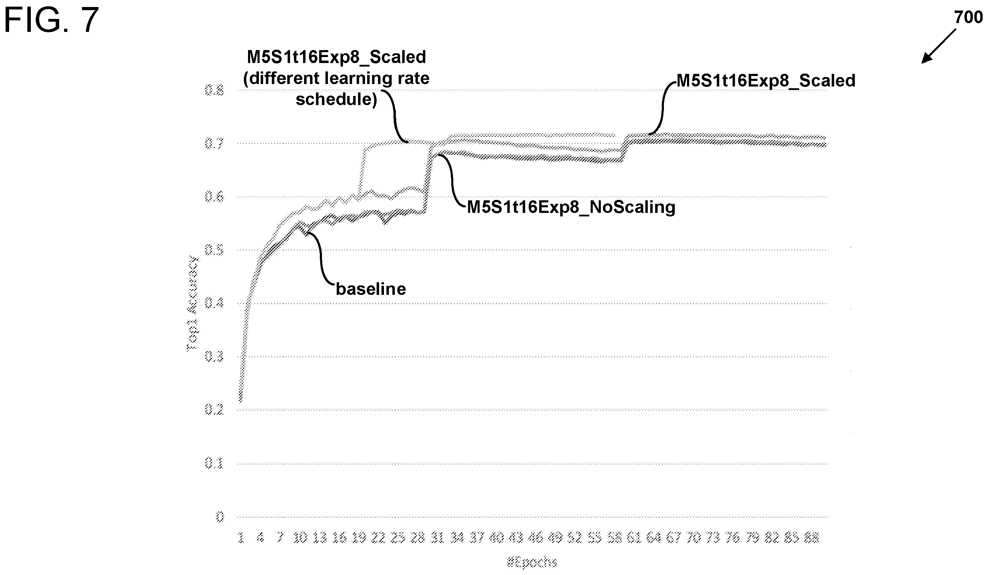

FIG. 7 is a chart 700 illustrating accuracy measured for a test neural network model having parameters quantized in an 8-bit shared exponent format with five mantissa bits and one sign bit, in accordance with the present disclosure. The test neural network model used in this experiment was a ResNet50 neural network having 16 layers, and the training was performed using the ImageNet database. In the baseline neural network, values of weights of the neural network were represented in a standard-precision float32 format. Results are charted for the baseline float32 model (represented by the plot labeled "baseline"), as well as for a model with parameters in the 8-bit shared exponent format with five mantissa bits and one sign bit without learning rate scaling (represented by the plot labeled "M5S1t16Exp8_NoScaling"), for the same model with learning rate scaling and a first learning rate schedule (represented by the plot labeled "M5S1t16Exp8 Scaled"), and for the same model with learning rate scaling and a second learning rate schedule different than the first learning rate schedule (represented by the plot labeled "M5S1t16Exp8_Scaled (different lr schedule)"). Other parameters of the experiment included batch normalization, post-quantized gradients, and utilization of the Keras library.

As shown, the accuracy and number of epochs to convergence of the quantized model without learning rate scaling are similar to that of the baseline model. Scaling the learning rate improves the accuracy and number of epochs to convergence of both of the quantized models with learning rate scaling. For example, scaling the learning rate improves the accuracy of the quantized models by approximately 1.24% compared to the accuracy of the quantized model without learning rate scaling. Further, using a different learning rate schedule, the number of epochs to convergence for the quantized model can be significantly reduced. In particular, as shown, using the second learning rate schedule when training the quantized model with learning rate scaling reduced the number of epochs to convergence by almost 50%. These results provide further evidence that scaling the learning rate in the disclosed manner can advantageously improve the accuracy and efficiency of training of a quantized neural network, thereby improving the operation of the computing hardware used to implement the training. In addition, these results show that adjusting the learning rate schedule can provide further improvements by reducing the number of training epochs to convergence, which in turn allows the computing hardware used to implement the training to operate more efficiently.

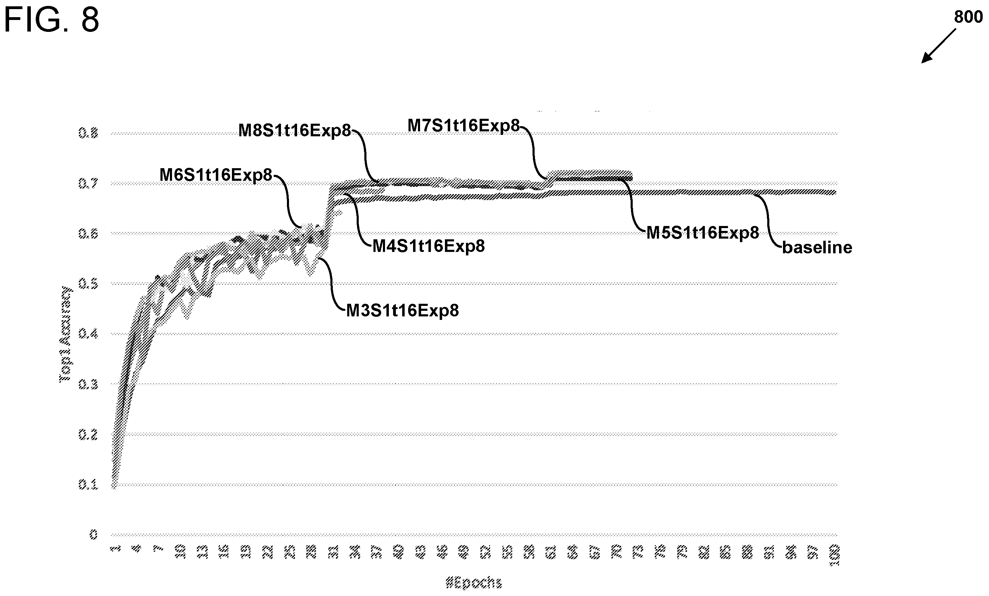

FIG. 8 is a chart 800 illustrating accuracy measured for a test neural network model having parameters quantized in an 8-bit shared exponent format with one sign bit and different numbers of mantissa bits. In this experiment, all results aside from the baseline were obtained using scaled learning rates, in accordance with the present disclosure. The test neural network model used in this experiment was a ResNet50 neural network having 16 layers, and the training was performed using the ImageNet database. In the baseline neural network, values of weights of the neural network were represented in a normal-precision float32 format. Results are charted for the baseline float32 model (represented by the plot labeled "baseline"), as well as for quantized models with scaled learning rates having parameters in the 8-bit shared exponent format with one sign bit and either three, four, five, six, seven, or eight mantissa bits (represented by the plots labeled "M3S1t16Exp8," "M4S1t16Exp8," "M5S1t16Exp8," "M6S1t16Exp8," "M7S1t16Exp8," and "M8S1t16Exp8," respectively). Other parameters of the experiment included batch normalization, post-quantized gradients, and utilization of the TensorFlow library.

As shown in FIG. 8, all but one of the quantized models with scaled learning rates achieve higher accuracy as compared to the baseline model. Specifically, the quantized models with scaled learning rates having parameters in the 8-bit shared exponent format with one sign bit and either four, five, six, seven, or eight mantissa bits achieve a higher accuracy than the non-quantized baseline model, whereas the quantized model with a scaled learning rate having parameters in the 8-bit shared exponent format with one sign bit and three mantissa bits is less accurate than the baseline model. As evidenced by the results of this experiment, the baseline model still needs modification to match state-of-the-art accuracy.

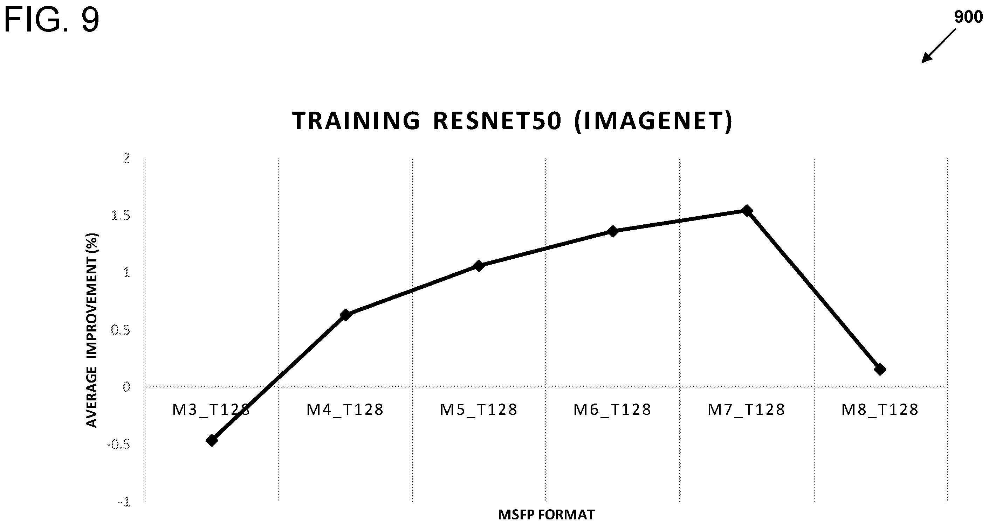

FIG. 9 is a chart 900 illustrating the average accuracy improvement achieved, relative to a non-quantized baseline model, for experiments using scaled learning rates for parameters having different quantized formats. The test neural network model used in this experiment was a ResNet50 neural network having 128 layers, and the training was performed using the ImageNet database. In the baseline neural network, values of weights of the neural network were represented in a normal-precision float32 format. The average accuracy improvement achieved by using a scaled learning rate, relative to the baseline model, is shown for quantized models having parameters in the 8-bit shared exponent format with either three, four, five, six, seven, or eight mantissa bits (represented by the areas labeled "M3_T128," "M4_T128," "M5_T128," "M6_T128," "M7_T128," and "M8_T128," respectively). Other parameters of the experiment included post-quantized gradients and utilization of the TensorFlow library.

As shown in FIG. 9, the average percentage of improvement in accuracy achieved by using a scaled learning rate varies depending on the level of precision of the quantized format. It will be appreciated that the M8_T128 model is more precise than the M7_T128 model, which is more precise than the M6_T128 model, and so on, due to the relative numbers of mantissa bits in the models. In this experiment, accuracy improvements were achieved for the models having four, five, six, seven, and eight mantissa bits, with the highest accuracy improvement (greater than 1.5%) being achieved by the model having 7 mantissa bits (M7_T128).

However, the accuracy improvement for the model having 8 mantissa bits was minimal; the accuracy achieved by that model with a scaled learning rate was roughly equivalent to that achieved by the same model without a scaled learning rate. Thus, for quantized formats having a relatively high signal-to-quantized-noise ratio (e.g., the model having 8 mantissa bits), training with a scaled learning rate may provide accuracy equivalent to that achieved by training without scaling the learning rate. Further, the accuracy achieved by the model having 3 mantissa bits was lower than that achieved by training without scaling the learning rate. These results indicate that for quantized formats having a relatively low signal-to-quantized-noise ratio (e.g., the model having 3 mantissa bits), scaling the learning rate may not improve accuracy as the amount of quantization noise is dominant.

Therefore, by scaling the learning rate used in training of certain types of quantized-format neural network tensors, improved performance can be achieved. Such performance gains would not be as readily achieved without the methods and apparatus disclosed herein, based on, for example, reduced programmer productivity and effort required to achieve an acceptable level of accuracy when training a quantized neural network. Hence, improved programmer productivity and ultimately improved hardware acceleration (via use of quantized-precision formats) can be achieved using certain disclosed methods and apparatus.

## XI. Additional Examples of the Disclosed Technology

Additional examples of the disclosed technology are disclosed in accordance with the examples above.

In some examples of the disclosed technology, a neural network implemented with a quantization-enabled system can be trained by the method including, with the quantization-enabled system, obtaining a tensor comprising values of one or more parameters of the neural network represented in a quantized-precision format, generating at least one noise-to-signal metric representing quantization noise present in the tensor, and generating a scaled learning rate based on the at least one noise-to-signal metric. The method can further include performing an epoch of training of the neural network using the values of the tensor, including computing one or more gradient updates using the scaled learning rate.

In some examples, the tensor is a second tensor obtained by converting values of a first tensor from a normal-precision floating-point format to the quantized-precision format, and the one or more parameters are weights used in a forward-propagation phase of a training epoch of the neural network. Further, in some examples, the one or more parameters represent edge weights and activation weights of the neural network, and generating the at least one noise-to-signal metric includes, for each of a plurality of layers of the neural network, generating a noise-to-signal ratio for the activation weights of the layer and generating a noise-to-signal ratio for the edge weights of the layer.

In some examples, generating the noise-to-signal ratio for the activation weights of each of the plurality of layers includes computing the difference between the activation weights of the second tensor for that layer and the activation weights of the first tensor for that layer, and dividing the difference by the absolute value of the activation weights of the first tensor for that layer. Similarly, in some examples, generating the noise-to-signal ratio for the edge weights of each of the plurality of layers includes computing the difference between the edge weights of the second tensor for that layer and the edge weights of the first tensor for that layer, and dividing the computed difference by the absolute value of the edge weights of the first tensor for that layer.

In some examples, the method further includes generating a scaling factor based on the at least one noise-to-signal metric. For example, for a neural network that includes a total of $L$ layers, the scaling factor for a layer $l$ of the neural network can be generated based on an average value of the noise-to-signal ratio for the activation weights of the layer $l$ as well as a sum of average values of the noise-to-signal ratios for the edge weights of layers $l + 1$ through $L$ of the neural network. Further, in some examples, training the neural network includes training the neural network via stochastic gradient descent. In such examples, the scaled learning rate for the layer $l$ of the neural network can be computed by the equation:

$$\varepsilon_q = \frac{\varepsilon}{1 + \mathbf{E}\left[\frac{\xi^{(l)}}{X^{(l)}}\right] + \sum_{k=l+1}^{L} E\left[\frac{\gamma^{(k)}}{W^{(k)}}\right]}$$

wherein $\varepsilon_q$ represents the scaled learning rate, $\varepsilon$ represents a predetermined learning rate of the neural network, $\mathbf{E}\left[\frac{\xi^{(l)}}{X^{(l)}}\right]$ represents the average value of the noise-to-signal ratio for the activation weights of the layer $l$ over a stochastic gradient descent batch size, in the form of a vector, and $E\left[\frac{\gamma^{(k)}}{W^{(k)}}\right]$ represents the average value of the noise-to-signal ratio for the edge weights of a layer $k$ of the neural network, per sample, in the form of a matrix.

In some examples, computing the one or more gradient updates using the scaled learning rate includes computing gradient updates for one or more parameters of the layer $l$ using the scaled learning rate. Additionally or alternatively, computing the one or more gradient updates using the scaled learning rate can include computing gradient updates for one or more parameters of one or more other layers of the neural network using the same scaled learning rate generated for the layer *l*.

In some examples, the method further includes generating a scaling factor based on the at least one noise-to-signal metric. In such examples, the normal-precision floating-point format can represent the values with a first bit width, the quantized-precision format can represent the values with a second bit width, the second bit width being lower than the first bit width, and the method can further include storing the scaling factor in an entry for the second bit width in a lookup table; computing gradient updates for one or more other parameters of the neural network represented with the second bit width by accessing the entry for the second bit width in the lookup table to obtain the scaling factor for the second bit width; and computing the gradient updates for the one or more other parameters using the scaling factor for the second bit width.

In some examples, the epoch of training of the neural network is a second epoch performed after a first epoch of training of the neural network. In such examples, the method can further include, prior to generating the scaled learning rate, performing the first epoch of training using the values of the tensor, including computing one or more gradient updates using a predetermined learning rate of the neural network. Further, generating the scaled learning rate based on the at least one noise-to-signal metric can include scaling the predetermined learning rate based on the at least one noise-to-signal metric.

In some examples of the disclosed technology, a system for training a neural network implemented with a quantization-enabled system can include memory; one or more processors coupled to the memory and adapted to perform quantized-precision operations; and one or more computer-readable storage media storing computer-readable instructions that, when executed by the one or more processors, cause the system to perform a method of training a neural network. The one or more processors can include a neural network accelerator having a tensor processing unit, for example.

The method can include instructions that cause the system to represent values of one or more parameters of the neural network in a quantized-precision format; instructions that cause the system to compute at least one metric representing quantization noise present in the values represented in the quantized-precision format; and instructions that cause the system to adjust a learning rate of the neural network based on the at least one metric.

In some examples, the one or more parameters of the neural network include a plurality of weights of a layer of the neural network; and the at least one metric includes a noise-to-signal ratio. The noise-to-signal ratio can be computed by computing a difference between values of the weights represented in the quantized-precision format and values of the weights represented in a normal-precision floating-point format, and dividing the difference by an absolute value of the values of the weights represented in the normal-precision floating-point format.

In some examples, the one or more parameters can include activation weights and edge weights of a first layer of the neural network. In such examples, computing the at least one metric can include computing a first noise-to-signal ratio for the activation weights of the first layer and a second noise-to-signal ratio for the edge weights of the first layer, and the system can further include instructions that cause the system to train the neural network with at least some values of the parameters represented in the quantized-precision format, including instructions that cause the system to compute gradient updates for the first layer and at least one other layer of the neural network using the adjusted learning rate.

In some examples, the one or more parameters can include weights of a first layer of the neural network and weights of a second layer of the neural network. In such examples, the instructions that cause the system to compute the at least one metric can include instructions that cause the system to compute a first noise-to-signal ratio for the weights of the first layer and a second noise-to-signal ratio for the weights of the second layer. Further, the instructions that cause the system to adjust the learning rate based on the at least one metric can include instructions that cause the system to compute a first scaling factor for the first layer based on the first noise-to-signal ratio; compute a scaled learning rate for the first layer by scaling a global learning rate of the neural network using the first scaling factor; compute a second scaling factor for the second layer based on the second noise-to-signal ratio; and compute a scaled learning rate for the first layer by scaling a global learning rate of the neural network using the first scaling factor. The system can further include instructions that cause the system to train the neural network with the weights of the first and second layers represented in the quantized-precision format, including computing a first gradient update for the weights of the first layer using the scaled learning rate for the first layer and computing a second gradient update for the weights of the second layer using the scaled learning rate for the second layer.

In some examples of the disclosed technology, a method for compensating for noise during training of a neural network can include computing at least one noise-to-signal ratio representing noise present in the neural network; adjusting a hyper-parameter of the neural network based on the at least one noise-to-signal ratio; and training the neural network using the adjusted hyper-parameter. The hyper-parameter can include at least one of: a learning rate, a learning rate schedule, a bias, a stochastic gradient descent batch size, a number of neurons in the neural network, or a number of layers in the neural network. Alternatively, other hyper-parameters can be used.

In some examples, computing the at least one noise-to-signal ratio includes obtaining a first tensor comprising values of one or more parameters of the neural network before introducing noise to the neural network; introducing noise to the neural network; obtaining a second tensor comprising values of the one or more parameters after the introduction of noise to the neural network; computing the difference between one or more values of the second tensor and one or more corresponding values of the first tensor; and dividing the difference by the absolute value of the one or more corresponding values of the first tensor.

In some examples, introducing noise to the neural network can include one or more of the following: changing a data type of values of one or more parameters of the neural network. decreasing a stochastic gradient descent batch size for one or more layers of the neural network, reducing a voltage supplied to hardware implementing the neural network, implementing analog-based training of the neural network, or storing values of one or more parameters of the neural network in DRAM.

In some examples, adjusting the hyper-parameter based on the at least one noise-to-signal ratio includes computing a scaling factor based on the at least one noise-to-signal ratio; and scaling the hyper-parameter using the scaling factor. As discussed herein, the hyper-parameter can be adjusted to compensate for the effect of the noise present in the neural network on the accuracy of gradient updates computed during the training of the neural network.

In view of the many possible embodiments to which the principles of the disclosed subject matter may be applied, it should be recognized that the illustrated embodiments are only preferred examples and should not be taken as limiting the scope of the claimed subject matter. Rather, the scope of the claimed subject matter is defined by the following claims. We therefore claim as our invention all that comes within the scope of these claims.

**Claims**

1. A method for training a neural network implemented with a quantization-enabled computing system (110), the method comprising:

   with the quantization-enabled computing system:

   obtaining (320) a tensor comprising values of one or more parameters of the neural network represented in a quantized-precision format;
   generating (330, 420) at least one noise-to-signal ratio representing quantization noise present in the tensor;
   generating (340, 350, 430) a scaled learning rate and at least one hyper-parameter among a learning rate schedule, a bias, a stochastic gradient descent batch size, a number of neurons in the neural network and a number of layers in the neural network, based on the at least one noise-to-signal ratio; and
   performing an epoch of training (360, 440) of the neural network using the values of the tensor, including computing one or more gradient updates using the scaled learning rate to compensate for the quantization noise.

2. The method of claim 1, wherein:

   the tensor is a second tensor obtained by converting values of a first tensor from a normal-precision floating-point format to the quantized-precision format, and
   the one or more parameters are weights used in a forward-propagation phase of a training epoch of the neural network.

3. The method of claim 2, wherein:

   the one or more parameters represent edge weights and activation weights of the neural network, and
   generating the at least one noise-to-signal ratio comprises, for each of a plurality of layers of the neural network, generating a noise-to-signal ratio for the activation weights of the layer and generating a noise-to-signal ratio for the edge weights of the layer.

4. The method of claim 3, wherein:

   generating the noise-to-signal ratio for the activation weights of each of the plurality of layers comprises computing the difference between the activation weights of the second tensor for that layer and the activation weights of the first tensor for that layer, and dividing the difference by the absolute value of the activation weights of the first tensor for that layer; and
   generating the noise-to-signal ratio for the edge weights of each of the plurality of layers comprises computing the difference between the edge weights of the second tensor for that layer and the edge weights of the first tensor for that layer, and dividing the difference by the absolute value of the edge weights of the first tensor for that layer.

5. The method of claim 3, further comprising generating a scaling factor based on the at least one noise-to-signal ratio, wherein:

the neural network comprises a total of L layers; and
the scaling factor for a layer *l* of the neural network is generated based on an average value of the noise-to-signal ratio for the activation weights of the layer *l* as well as a sum of average values of the noise-to-signal ratios for the edge weights of layers *l* + 1 through L of the neural network.

6. The method of claim 5, wherein:

training the neural network comprises training the neural network via stochastic gradient descent; and
the scaled learning rate for the layer *l* of the neural network is computed by the equation:

$$\varepsilon_q = \frac{\varepsilon}{1 + \mathbf{E}\left[\frac{\xi^{(l)}}{X^{(l)}}\right] + \sum_{k=l+1}^{L} E\left[\frac{\gamma^{(k)}}{w^{(k)}}\right]}$$

wherein $\varepsilon_q$ represents the scaled learning rate, $\varepsilon$ represents a predetermined learning rate of the neural network,

$\mathbf{E}\left[\frac{\xi^{(l)}}{X^{(l)}}\right]$ represents the average value of the noise-to-signal ratio for the activation weights of the layer *l* over a stochastic gradient descent batch size, in the form of a vector, and $E\left[\frac{\gamma^{(k)}}{w^{(k)}}\right]$ represents the average value of the
noise-to-signal ratio for the edge weights of a layer k of the neural network, per sample, in the form of a matrix.

7. The method of claim 6, wherein computing the one or more gradient updates using the scaled learning rate comprises computing gradient updates for one or more parameters of the layer *l* using the scaled learning rate.

8. The method of claim 7, wherein computing the one or more gradient updates using the scaled learning rate further comprises computing gradient updates for one or more parameters of one or more other layers of the neural network using the same scaled learning rate generated for the layer *l*.

9. The method of claim 2, further comprising generating a scaling factor based on the at least one noise-to-signal ratio, wherein:

the normal-precision floating-point format represents the values with a first bit width;
the quantized-precision format represents the values with a second bit width, the second bit width being lower than the first bit width; and
the method further comprises:

storing the scaling factor in an entry for the second bit width in a lookup table;
computing gradient updates for one or more other parameters of the neural network represented with the second bit width by accessing the entry for the second bit width in the lookup table to obtain the scaling factor for the second bit width; and
computing the gradient updates for the one or more other parameters using the scaling factor for the second bit width.

10. The method of claim 1, wherein the epoch of training of the neural network is a second epoch performed after a first epoch of training of the neural network, the method further comprising:

prior to generating the scaled learning rate, performing the first epoch of training using the values of the tensor, including computing one or more gradient updates using a predetermined learning rate of the neural network, wherein generating the scaled learning rate based on the at least one noise-to-signal ratio comprises scaling the predetermined learning rate based on the at least one noise-to-signal ratio.

11. A system for training a neural network implemented with a quantization-enabled system, the system comprising:

memory;

one or more processors coupled to the memory and adapted to perform quantized-precision operations;

one or more computer-readable storage media storing computer-readable instructions that, when executed by the one or more processors, cause the system to perform a method of training a neural network, the instructions comprising:

instructions that cause the system to represent values of one or more parameters of the neural network in a quantized-precision format;

instructions that cause the system to compute at least one noise-to-signal ratio representing quantization noise present in the values represented in the quantized-precision format;

instructions that cause the system to adjust a learning rate of the neural network and at least one hyper-parameter among a learning rate schedule, a bias, a stochastic gradient descent batch size, a number of neurons in the neural network and a number of layers in the neural network, based on the at least one noise-to-signal ratio; and

instructions that cause the system to train the neural network with at least some values of the parameters represented in the quantized-precision format, including instructions that cause the system to compute gradient updates for the first layer and at least one other layer of the neural network using the adjusted learning rate to compensate for the quantization noise.

**12.** The system of claim 11, wherein:

the one or more parameters of the neural network comprise a plurality of weights of a layer of the neural network; and

the noise-to-signal ratio is computed by computing a difference between values of the weights represented in the quantized-precision format and values of the weights represented in a normal-precision floating-point format, and dividing the difference by an absolute value of the values of the weights represented in the normal-precision floating-point format.

**13.** The system of claim 11, wherein:

the one or more parameters comprise activation weights and edge weights of a first layer of the neural network; and

computing the at least one noise-to-signal ratio comprises computing a first noise-to-signal ratio for the activation weights of the first layer and a second noise-to-signal ratio for the edge weights of the first layer.

**14.** The system of claim 11, wherein the one or more processors comprise a neural network accelerator (180) having a tensor processing unit.

**15.** The system of claim 11, wherein the learning rate is adjusted to compensate for the effect of the quantization noise on the accuracy of gradient updates computed during subsequent training of the neural network.

**Patentansprüche**

**1.** Verfahren zum Trainieren eines neuronalen Netzwerks, implementiert mit einem quantisierungsfähigen Computersystem (110), wobei das Verfahren umfasst:
mit dem quantisierungsfähigen Computersystem:

Ermitteln (320) eines Tensors, umfassend Werte eines oder mehrerer Parameter des neuronalen Netzwerks, dargestellt in einem Format mit quantisierter Präzision;

Erzeugen (330, 420) wenigstens eines Rausch-Signal-Verhältnisses zur Darstellung des im Tensor vorhandenen Quantisierungsrauschens;

Erzeugen (340, 350, 430) einer skalierten Lernrate und wenigstens eines Hyperparameters von einem Lernratenplan, einem Bias, einer stochastischen Gradientenabstiegs-Batchgröße, einer Zahl von Neuronen im neuronalen Netzwerk und einer Zahl von Schichten im neuronalen Netzwerk, basierend auf dem wenigstens einen Rauschen-Signal-Verhältnis; und

Durchführen einer Trainingsepoche (360, 440) des neuronalen Netzwerks unter Verwendung der Werte des Tensors, umfassend das Berechnen von einer oder mehreren Gradientenaktualisierungen unter Verwendung der skalierten Lernrate, um das Quantisierungsrauschen zu kompensieren.

2. Verfahren nach Anspruch 1, wobei:
der Tensor ein zweiter Tensor ist, erhalten durch Umwandeln von Werten eines ersten Tensors von einem Gleitkommaformat normaler Präzision in das Format mit quantisierter Präzision, und der eine oder die mehreren Parameter Gewichte sind, verwendet in einer Vorwärtspropagierungsphase einer Trainingsepoche des neuronalen Netzwerks.

3. Verfahren nach Anspruch 2, wobei:

der eine oder die mehreren Parameter Kantengewichte und Aktivierungsgewichte des neuronalen Netzwerks darstellen, und
das Erzeugen des wenigstens einen Rauschen-Signal-Verhältnisses, für jede einer Vielzahl von Schichten des neuronalen Netzwerks das Erzeugen eines Rauschen-Signal-Verhältnisses für die Aktivierungsgewichte der Schicht und das Erzeugen eines Rauschen-Signal-Verhältnisses für die Kantengewichte der Schicht umfasst.

4. Verfahren nach Anspruch 3, wobei:

das Erzeugen des Rauschen-Signal-Verhältnisses für die Aktivierungsgewichte von jeder der Vielzahl von Schichten das Berechnen der Differenz zwischen den Aktivierungsgewichten des zweiten Tensors für diese Schicht und den Aktivierungsgewichten des ersten Tensors für diese Schicht und das Dividieren der Differenz durch den Absolutwert der Aktivierungsgewichte des ersten Tensors für diese Schicht umfasst; und
das Erzeugen des Rausch-Signal-Verhältnisses für die Kantengewichte von jeder der Vielzahl von Schichten das Berechnen der Differenz zwischen den Kantengewichten des zweiten Tensors für diese Schicht und den Kantengewichten des ersten Tensors für diese Schicht und das Dividieren der Differenz durch den Absolutwert der Kantengewichte des ersten Tensors für diese Schicht umfasst.

5. Verfahren nach Anspruch 3, ferner umfassend das Erzeugen eines Skalierungsfaktors auf Basis des wenigstens einen Rauschen-Signal-Verhältnisses, wobei:

das neuronale Netzwerk insgesamt $L$ Schichten umfasst; und
der Skalierungsfaktor für eine Schicht $l$ des neuronalen Netzwerks auf der Basis eines Durchschnittswerts des Rauschen-Signal-Verhältnisses für die Aktivierungsgewichte der Schicht $l$ sowie einer Summe von Durchschnittswerten der Rauschen-Signal-Verhältnisse für die Kantengewichte von Schichten $l + 1$ durch $L$ des neuronalen Netzwerks erzeugt wird.

6. Verfahren nach Anspruch 5, wobei:

das Training des neuronalen Netzwerks das Training des neuronalen Netzwerks über einen stochastischen Gradientenabstieg umfasst; und
die skalierte Lernrate für die Schicht $l$ des neuronalen Netzwerks durch folgende Gleichung berechnet wird:

$$\varepsilon_q = \frac{\varepsilon}{1 + \mathbf{E}\left[\frac{\xi^{(l)}}{X^{(l)}}\right] + \sum_{k=l+1}^{L} E\left[\frac{\gamma^{(k)}}{w^{(k)}}\right]}$$

wobei $\varepsilon_q$ die skalierte Lernrate darstellt, $\varepsilon$ eine vorbestimmte Lernrate des neuronalen Netzwerks darstellt, $\mathbf{E}\left[\frac{\xi^{(l)}}{X^{(l)}}\right]$ den Durchschnittswert des Rauschen-Signal-Verhältnisses für die Aktivierungsgewichte der Schicht $l$ über eine stochastischen Gradientenabstiegs-Batchgröße in der Form eines Vektors darstellt und $E\left[\frac{\gamma^{(k)}}{w^{(k)}}\right]$ den Durchschnittswert des Rauschen-Signal-Verhältnisses für die Kantengewichte einer Schicht k des neuronalen Netzwerks pro Abtastwert in der Form einer Matrix darstellt.

7. Verfahren nach Anspruch 6, wobei das Berechnen der einen oder mehreren Gradientenaktualisierungen unter Verwendung der skalierten Lernrate die Berechnung von Gradientenaktualisierungen für einen oder mehrere Parameter der Schicht $l$ unter Verwendung der skalierten Lernrate umfasst.

8. Verfahren nach Anspruch 7, wobei das Berechnen der einen oder mehreren Gradientenaktualisierungen unter Verwendung der skalierten Lernrate ferner das Berechnen von Gradientenaktualisierungen für einen oder mehrere Parameter einer oder mehrerer anderer Schichten des neuronalen Netzwerks unter Verwendung der gleichen für die Schicht erzeugten skalierten Lernrate umfasst.

9. Verfahren nach Anspruch 2, ferner umfassend das Erzeugen eines Skalierungsfaktors auf Basis des wenigstens einen Rauschen-Signal-Verhältnisses, wobei:

das Gleitkommaformat mit normaler Präzision die Werte mit einer ersten Bitbreite darstellt;
das Format mit quantisierter Präzision die Werte mit einer zweiten Bitbreite darstellt, wobei die zweite Bitbreite niedriger ist als die erste Bitbreite; und
wobei das Verfahren ferner umfasst:

Speichern des Skalierungsfaktors in einem Eintrag für die zweite Bitbreite in einer Nachschlagetabelle;
Berechnen von Gradientenaktualisierungen für einen oder mehrere andere Parameter des neuronalen Netzwerks, dargestellt mit der zweiten Bitbreite, durch Zugreifen auf den Eintrag für die zweite Bitbreite in der Nachschlagetabelle, um den Skalierungsfaktor für die zweite Bitbreite zu erhalten; und
Berechnen der Gradientenaktualisierungen für den einen oder die mehreren anderen Parameter unter Verwendung des Skalierungsfaktors für die zweite Bitbreite.

10. Verfahren nach Anspruch 1, wobei die Trainingsepoche des neuronalen Netzwerks eine zweite Epoche ist, die nach einer ersten Trainingsepoche des neuronalen Netzwerks durchgeführt wird, wobei das Verfahren ferner umfasst:

vor dem Erzeugen der skalierten Lernrate, Durchführen der ersten Trainingsepoche unter Verwendung der Werte des Tensors, umfassend das Berechnen von einem oder mehreren Gradientenaktualisierungen unter Verwendung einer vorbestimmten Lernrate des neuronalen Netzwerks,
wobei das Erzeugen der skalierten Lernrate auf Basis des wenigstens einen Rauschen-Signal-Verhältnisses das Skalieren der vorbestimmten Lernrate auf Basis des mindestens einen Rauschen-Signal-Verhältnisses umfasst.

11. System zum Trainieren eines neuronalen Netzwerks, implementiert mit einem quantisierungsfähigen System, wobei das System umfasst:

Speicher;
einen oder mehrere Prozessoren, gekoppelt mit dem Speicher und angepasst zum Durchführen von Vorgängen mit quantisierter Präzision;
ein oder mehrere computerlesbare Speichermedien zum Speichern von computerlesbaren Anweisungen, die, wenn vom einen oder von den mehreren Prozessoren ausgeführt, das System veranlassen, ein Verfahren zum Trainieren eines neuronalen Netzwerks auszuführen, wobei die Anweisungen umfassen:

Anweisungen, die das System veranlassen, Werte eines oder mehrerer Parameter des neuronalen Netzwerks in einem Format mit quantisierter Präzision darzustellen;
Anweisungen, die das System veranlassen, wenigstens ein Rauschen-Signal-Verhältnis zu berechnen, welches das Quantisierungsrauschen darstellt, das in den im Format mit quantisierter Präzision dargestellten Werten vorhanden ist;
Anweisungen, die das System veranlassen, eine Lernrate des neuronalen Netzwerks und wenigstens einen Hyperparameter von einem Lernratenplan, einem Bias, einer stochastischen Gradientenabstiegs-Batchgröße, einer Zahl von Neuronen im neuronalen Netzwerk und einer Zahl von Schichten im neuronalen Netzwerk, basierend auf dem wenigstens einen Rauschen-Signal-Verhältnis, anzupassen; und
Anweisungen, die das System veranlassen, das neuronale Netzwerk mit wenigstens einigen Werten der Parameter zu trainieren, die im Format mit quantisierter Präzision dargestellt sind, umfassend
Anweisungen, die das System veranlassen, Gradientenaktualisierungen für die erste Schicht und wenigstens eine andere Schicht des neuronalen Netzwerks unter Verwendung der angepassten Lernrate zu berechnen, um das Quantisierungsrauschen zu kompensieren.

12. System nach Anspruch 11, wobei:

der eine oder die mehreren Parameter des neuronalen Netzwerks eine Vielzahl von Gewichten einer Schicht des neuronalen Netzwerks umfassen; und

das Rauschen-Signal-Verhältnis berechnet wird, indem eine Differenz zwischen Werten der Gewichte, dargestellt im Format mit quantisierter Präzision, und Werten der Gewichte, dargestellt in einem Gleitkommaformat mit normaler Präzision, berechnet wird und die Differenz durch einen Absolutwert der Werte der Gewichte, dargestellt im Gleitkommaformat mit normaler Präzision, dividiert wird.

13. System nach Anspruch 11, wobei:

der eine oder die mehreren Parameter Aktivierungsgewichte und Kantengewichte einer ersten Schicht des neuronalen Netzwerks umfassen; und

das Berechnen des wenigstens einen Rauschen-Signal-Verhältnisses das Berechnen eines ersten Rauschen-Signal-Verhältnisses für die Aktivierungsgewichte der ersten Schicht und eines zweiten Rauschen-Signal-Verhältnisses für die Kantengewichte der ersten Schicht umfasst.

14. System nach Anspruch 11, wobei der eine oder die mehreren Prozessoren einen Neuronal-Netzwerk-Beschleuniger (180) mit einer Tensor-Verarbeitungseinheit umfassen.

15. System nach Anspruch 11, wobei die Lernrate angepasst wird, um die Wirkung des Quantisierungsrauschens auf die Genauigkeit der Gradientenaktualisierungen, berechnet während des nachfolgenden Trainings des neuronalen Netzwerks, zu kompensieren.

**Revendications**

1. Procédé pour entraîner un réseau neuronal mis en œuvre avec un système informatique autorisant une quantification (110), le procédé comprenant :
avec le système informatique autorisant une quantification :

une obtention (320) d'un tenseur comprenant des valeurs d'un ou plusieurs paramètres du réseau neuronal représentées dans un format de précision quantifiée ;

une génération (330, 420) d'au moins un rapport signal/bruit représentant du bruit de quantification présent dans le tenseur ;

une génération (340, 350, 430) d'un taux d'apprentissage mis à l'échelle et d'au moins un hyperparamètre au sein d'une planification de taux d'apprentissage, un biais, une taille de lot de descente de gradient stochastique, un nombre de neurones dans le réseau neuronal et un nombre de couches dans le réseau neuronal, selon l'au moins un rapport signal/bruit ; et

une exécution d'une epoch d'entraînement (360, 440) du réseau neuronal en utilisant les valeurs du tenseur, notamment un calcul d'une ou plusieurs actualisations de gradient au moyen du taux d'apprentissage mis à l'échelle pour compenser le bruit de quantification.

2. Le procédé de la revendication 1, dans lequel :

le tenseur est un deuxième tenseur obtenu en convertissant des valeur d'un premier tenseur d'un format à virgule flottante de précision normale en le format de précision quantifiée, et

l'un ou plusieurs paramètres sont des poids utilisés pour une phase de propagation vers l'avant d'une epoch d'entraînement du réseau neuronal.

3. Le procédé de la revendication 2, dans lequel :

l'un ou plusieurs paramètres représentent des poids marginaux et des poids d'activation du réseau neuronal, et une génération de l'au moins un rapport signal/bruit comprend, pour chacune d'une pluralité de couches du réseau neuronal, une génération d'un rapport signal/bruit pour les poids d'activation de la couche et une génération d'un rapport signal/bruit pour les poids marginaux de la couche.

4. Le procédé de la revendication 3, dans lequel :

une génération du rapport signal/bruit pour les poids d'activation de chacune de la pluralité de couches comprend un calcul de la différence entre les poids d'activation du deuxième tenseur pour cette couche et les poids d'activation du premier tenseur pour cette couche, et une division de la différence par la valeur absolue des poids d'activation du premier tenseur pour cette couche ; et

une génération du rapport signal/bruit pour les poids marginaux de chacune de la pluralité de couches comprend un calcul de la différence entre les poids marginaux du deuxième tenseur pour cette couche et les poids marginaux du premier tenseur pour cette couche, et une division de la différence par la valeur absolue des poids marginaux du premier tenseur pour cette couche.

5. Le procédé de la revendication 3 comprend en outre une génération d'un facteur de mise à l'échelle selon l'au moins un rapport signal/bruit, dans lequel :

le réseau neuronal comprend un total de L couches ; et

le facteur de mise à l'échelle pour une couche l du réseau neuronal est généré selon une valeur moyenne du rapport signal/bruit pour les poids d'activation de la couche *l* ainsi qu'une somme de valeurs moyennes des rapports signal/bruit pour les poids marginaux de couches *l* + 1 à *L* du réseau neuronal.

6. Le procédé de la revendication 5, dans lequel :

un entraînement du réseau neuronal comprend un entraînement du réseau neuronal via une descente de gradient stochastique ; et

le taux d'apprentissage mis à l'échelle pour la couche *l* du réseau de neurone est calculé par l'équation :

$$\varepsilon_q = \frac{\varepsilon}{1 + \mathbf{E}\left[\frac{\xi^{(l)}}{X^{(l)}}\right] + \sum_{k=l+1}^{L} E\left[\frac{\gamma^{(k)}}{W^{(k)}}\right]}$$

dans lequel $\varepsilon_q$ représente le taux d'apprentissage mis à l'échelle, $\varepsilon$ représente un taux d'apprentissage prédéterminé du réseau neuronal, $\mathbf{E}\left[\frac{\xi^{(l)}}{X^{(l)}}\right]$ représente la valeur moyenne du rapport signal/bruit pour les poids d'activation de la couche *l* sur une taille de lot de descente de gradient stochastique, sous la forme d'une vecteur, et $E\left[\frac{\gamma^{(k)}}{W^{(k)}}\right]$ représente la valeur moyenne du rapport signal/bruit pour les poids marginaux d'une couche k du réseau neuronal, par échantillon, sous la forme d'une matrice.

7. Le procédé de la revendication 6, dans lequel un calcul de l'une ou plusieurs actualisations de gradient au moyen du taux d'apprentissage mis à l'échelle comprend un calcul d'actualisations de gradient pour un ou plusieurs paramètres de la couche *l* en utilisant le taux d'apprentissage mis à l'échelle.

8. Le procédé de la revendication 7, dans lequel un calcul de l'une ou plusieurs actualisations de gradient au moyen du taux d'apprentissage mis à l'échelle comprend en outre un calcul d'actualisations de gradient pour un ou plusieurs paramètres d'une ou plusieurs autres couches du réseau neuronal en utilisant le même taux d'apprentissage mis à l'échelle généré pour la couche l.

9. Le procédé de la revendication 2, comprenant en outre une génération d'un facteur de mise à l'échelle selon l'au moins un rapport signal/bruit, dans lequel :

le format à virgule flottante de précision normale représente les valeurs avec un première largeur de bits ;

le format de précision quantifié représente les valeurs avec une deuxième largeur de bits, la deuxième largeur de bits étant inférieure à la première largeur de bits ; et

le procédé comprend en outre :

un stockage du facteur de mise à l'échelle dans une entrée pour la deuxième largeur de bits dans une table de consultation ;

un calcul d'actualisations de gradient pour un ou plusieurs autres paramètres du réseau neuronal représentés avec la deuxième largeur de bits en accédant à l'entrée pour la deuxième largeur de bits dans la table de consultation pour obtenir le facteur de mise à l'échelle pour la deuxième largeur de bits ; et

un calcul des actualisations de gradient pour l'un ou plusieurs autres paramètres en utilisant le facteur de mise à l'échelle pour la deuxième largeur de bits.

10. Le procédé de la revendication 1, dans lequel l'epoch d'entraînement du réseau neuronal est une deuxième epoch exécutée après une première epoch d'entraînement du réseau neuronal, le procédé comprenant en outre :

avant une génération du taux d'apprentissage mis à l'échelle, une exécution de la première epoch d'entraînement en utilisant les valeurs du tenseur, incluant un calcul d'une ou plusieurs actualisations de gradient au moyen d'un taux d'apprentissage prédéterminé du réseau neuronal,
dans lequel une génération du taux d'apprentissage mis à l'échelle selon l'au moins un rapport signal/bruit donné comprend une mise à l'échelle du taux d'apprentissage prédéterminé selon l'au moins un rapport signal/bruit.

11. Système pour entraîner un réseau neuronal mis en œuvre avec un système autorisant une quantification, le système comprenant :

une mémoire ;
un ou plusieurs processeurs couplés à la mémoire et adaptés pour exécuter des opérations de précision quantifiée ;
un ou plusieurs supports de stockage lisibles par un ordinateur stockant des instructions lisibles par un ordinateur qui, lorsqu'exécutées par l'un ou plusieurs processeurs, font exécuter au système un procédé d'entraînement d'un réseau neuronal, les instructions comprenant :

des instructions qui font représenter par le système des valeurs d'un ou plusieurs paramètres du réseau neuronal dans un format de précision quantifiée ;
des instructions qui font calculer par le système au moins un rapport signal/bruit représentant un bruit de quantification présent dans les valeurs représentées dans le format de précision quantifiée ;
des instructions qui font ajuster par le système un taux d'apprentissage du réseau neuronal et au moins un hyperparamètre au sein d'une planification de taux d'apprentissage, un biais, une taille de lot de descente de gradient stochastique, un nombre de neurones dans le réseau neuronal et un nombre de couches dans le réseau neuronal, selon l'au moins un rapport signal/bruit ; et
des instructions qui font entraîner par le système le réseau neuronal avec au moins certaines valeurs des paramètres représentés dans le format de précision quantifiée, incluant des instructions qui font calculer par le système des actualisations de gradient pour la première couche et au moins une autre couche du réseau neuronal au moyen du taux d'apprentissage ajusté pour compenser le bruit de quantification.

12. Le système de la revendication 11, dans lequel :

l'un ou plusieurs paramètres du réseau neuronal comprennent une pluralité de poids d'une couche du réseau neuronal ; et
le rapport signal/bruit est calculé en calculant une différence entre des valeurs des poids représentés dans le format de précision quantifiée et des valeurs des poids représentés dans un format à virgule flottante de précision normale, et en divisant la différence par une valeur absolue des valeurs des poids représentés dans le format à virgule flottante de précision normale.

13. Le système de la revendication 11, dans lequel :

l'un ou plusieurs paramètres comprennent des poids d'activation et des poids marginaux d'une première couche du réseau neuronal ; et
un calcul de l'au moins un rapport signal/bruit comprend un calcul d'un premier rapport signal/bruit pour les poids d'activation de la première couche et un deuxième rapport signal/bruit pour les poids marginaux de la première couche.

14. Le système de la revendication 11, dans lequel l'un ou plusieurs processeurs comprennent un accélérateur de réseau neuronal (180) présentant une unité de traitement de tenseur.

15. Le système de la revendication 11, dans lequel le taux d'apprentissage est ajusté pour compenser l'effet du bruit de quantification sur la précision d'actualisations de gradient calculées au cours d'un entraînement ultérieur du réseau neuronal.

# FIG. 1

100

## Quantization-Enabled System 110

**NN Accelerator 180**

| | |
|---|---|
| TPU 182 | Reconfigurable Logic Devices 184 |

| CPU 120 | GPU 122 | Memory 125 | Storage 127 |
|---|---|---|---|

## Normal-Precision Neural Network Module 130

200

| Modeling Framework 131 | Compiler 132 | Runtime Environment 133 |
|---|---|---|

## Quantization Domain 140

| Full-precision values 150 | → | FP->QFP Converter 152 | → | QFP Operations 154 | → | QFP->FP Converter 156 | → | Full-precision operations 158 |
|---|---|---|---|---|---|---|---|---|

NFP Domain     QFP Domain     NFP Domain

FIG. 2

# FIG. 3

300

310 — Obtain a first tensor for having one or more NN parameter values represented in a normal-precision floating-point format

320 — Obtain a second tensor having the values represented in a quantized-precision format

330 — Generate at least one noise-to-signal metric representing quantization noise in the second tensor

340 — Compute scaling factor based on the at least one noise-to-signal metric

350 — Scale learning rate using scaling factor

360 — Train NN

Use scaled learning rate to determine gradient updates

# FIG. 4

**400**

| 410 | Measure noise in the NN |
|---|---|

| 420 | Compute at least one noise-to-signal ratio for the NN using the measured noise |
|---|---|

| 430 | Adjust hyper-parameter of NN using the computed noise-to-signal ratio(s) |
|---|---|

| 440 | Train NN using adjusted hyper-parameter |
|---|---|

# FIG. 5

500

Computing Cloud
590

Software **580**
For described
technologies

Computing Environment

530

Processing
Unit(s)
510

NN
Accelerator(s)
515

Memory
520

Communication
Connection(s)   570

Input Device(s)
550

Output Device(s)
560

Storage
540

Instructions **580** for
described technologies

## FIG. 6

600

4M_1S_8Exp_bk16 (no scaling)   4M_1S_8Exp_bk16 (scaled)

2M_1S_8Exp_bk16 (scaled)

2M_1S_8Exp_bk16 (no scaling)

baseline

3M_1S_8Exp_bk16 (no scaling)

3M_1S_8Exp_bk16 (scaled)

1M_1S_8Exp_bk16 (no scaling)

1M_1S_8Exp_bk16 (scaled)

EP 3 899 801 B1

# FIG. 7

EP 3 899 801 B1

700

FIG. 8

FIG. 9

900

# TRAINING RESNET50 (IMAGENET)

AVERAGE IMPROVEMENT (%)

MSFP FORMAT

EP 3 899 801 B1

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20160328647 A1

**Non-patent literature cited in the description**

- Loss-aware Weight Quantization of Deep Networks. **LU HOU et al.** Arxiv.Org. Cornell University Library, 23 February 2018
- **YINPENG DONG et al.** *Learning Accurate Low-Bit Deep Neural Networks with Stochastic Quantization*, 03 August 2017
- Investigating the Effects of Dynamic Precision Scaling on Neural Network Training. **DYLAN MALONE STUART et al.** Arxiv.Org. Cornell University Library, 25 January 2018